# EUROPEAN PATENT APPLICATION

(11) **EP 2 461 386 A1**
(43) Date of publication of application: **06.06.2012**
(21) Application number: 10804253.2
(22) Date of filing: 12.07.2010
(51) Int. Cl.: H01L 51/50, H05B 33/10

(54) **ORGANIC ELECTROLUMINESCENT ELEMENT AND METHOD FOR MANUFACTURING SAME**

(30) Priority: 31.07.2009 JP 2009180124
(71) Applicant: FUJIFILM Corporation, Tokyo 106-8620 (JP)
(72) Inventor: SATO Tasuku, Ashigarakami-gun Kanagawa 258-8577 (JP); KAMINAGA Kuniyuki, Ashigarakami-gun Kanagawa 258-8577 (JP); HAYASHI Masayuki, Ashigarakami-gun Kanagawa 258-8577 (JP); TSUTSUMI Kiyohiko, Ashigarakami-gun Kanagawa 258-8577 (JP); FUJITA Mitsuhiro, Ashigarakami-gun Kanagawa 258-8577 (JP)
(74) Representative: Klunker . Schmitt-Nilson . Hirsch
(86) International application number: PCT/JP2010/061793
(87) International publication number: WO 2011/013507

(57) **Abstract**

An organic electroluminescent element including: a first electrode; at least one organic deposition layer; and a second electrode, the first electrode, the organic deposition layer, and the second electrode being formed in this order, wherein the organic deposition layer satisfies the relationship 0.093 < Ra/t < 0.340 where Ra denotes a surface roughness of a surface of the organic deposition layer, the surface being at the side of the second electrode, and t denotes a thickness of the organic deposition layer.

## Description

### Technical Field

The present invention relates to an organic electroluminescent element having excellent durability and a method for producing the organic electroluminescent element.

### Background Art

Organic EL elements have advantageous features such as self emission and high-speed response, and are expected for the application to flat panel displays. In particular, since such an organic electroluminescent element was reported that has a dual-layer structure (lamination type) in which a hole-transporting organic thin film (hole transport layer) is laminated on an electron-transporting organic thin film (electron transport layer), organic electroluminescent elements have been attracting attention as a large-area light-emitting element that emits light at a low voltage of 10 V or lower.

However, there still are problems on durability of elements, and various attempts have been made to improve durability for actual use.

For example, there has been disclosed an organic electroluminescent element improved in durability by roughening the surface of functional layers containing a luminescent layer (see PTL 1). This surface roughening improves the organic electroluminescent element in interlayer adhesiveness, and presumably prevents layer delamination which decreases durability.

In this case, however, the functional layers are formed by applying functional layer-forming materials through ink jetting, followed by drying, and they are difficult to be thin layers and also, there are concerns that the performances of the resultant element may be adversely affected by the residual solvent in the functional layers.

In addition, as an organic electroluminescent element having a roughened organic layer, there has been proposed an organic electroluminescent element including two electrodes facing each other, and two organic compound layers having different conductive carriers, wherein the organic compound layers are laminated via different layers on the electrodes, and the roughness of the different layers is different from that of the inner surface of at least one of the electrodes (see PTL 2).

However, there is no description on the conditions for improving the adhesiveness of the different layers in this organic electroluminescent element, and thus the adhesiveness cannot be improved.

Furthermore, there have been proposed other organic electroluminescent elements each having a roughened organic layer (see, for example, PTLs 3 and 4).

However, there are not disclosed proper conditions of the thickness and roughness of the functional layers for improving adhesiveness. Thus, at present, there has yet not been an organic electroluminescent element having satisfactorily excellent durability.

### Citation List

### Patent Literature

- PTL 1:: Japanese Patent Application Laid-Open (JP-A) No. 2005-310709
- PTL 2:: JP-A No. 2003-115381
- PTL 3:: JP-A No. 2002-313567
- PTL 4:: JP-A No. 2009-021343

### Summary of Invention

### Technical Problem

The present invention aims to solve the above existing problems and achieve the following objects. Specifically, an object of the present invention is to provide an organic electroluminescent element having high interlayer adhesiveness and durability, and a method for producing the organic electroluminescent element.

### Solution to Problem

The present inventors conducted extensive studies and have obtained the following findings on a thin-layer organic deposition layer formed through deposition.

That is, they have found that by adjusting the ratio Ra/t to a specific value, where Ra denotes a surface roughness of the organic deposition layer and t denotes a thickness of the organic layer, the adhesiveness between the organic layer and another layer to be disposed thereon due to surface irregularities of the organic layer is improved to suppress layer delamination potentially occurring as the element is driven. Moreover, another unexpected finding is that adjusting the Ra/t to a specific value can suppress increase rate of voltage over time and also improve durability for driving.

The present invention is based on the above findings obtained by the present inventors, and means for solving the above existing problems are as follows.
<1> An organic electroluminescent element including:
   a first electrode;
   at least one organic deposition layer; and
   a second electrode,
   the first electrode, the organic deposition layer, and the second electrode being formed in this order,
   wherein the organic deposition layer satisfies the relationship 0.093 < Ra/t < 0.340 where Ra denotes a surface roughness of a surface of the organic deposition layer, the surface being at the side of the second electrode, and t denotes a thickness of the organic deposition layer.
<2> The organic electroluminescent element according to <1>, wherein the organic deposition layer contains a luminescent layer, an adjacent layer to the luminescent layer, or both of the luminescent layer and the adjacent layer.
<3> The organic electroluminescent element according to <2>, wherein the adjacent layer is a hole transport layer.
<4> The organic electroluminescent element according to any one of <1> to <3>, wherein the first electrode is an anode and the second electrode is a cathode.
<5> The organic electroluminescent element according to any one of <2> to <4>, wherein the luminescent layer contains a phosphorescent material.
<6> The organic electroluminescent element according to <5>, wherein the phosphorescent material is a platinum complex.
<7> The organic electroluminescent element according to any one of <1> to <6>, wherein the thickness t of the organic deposition layer is 1 nm to 10 nm.
<8> A method for producing an organic electroluminescent element including a first electrode, at least one organic deposition layer containing a luminescent layer, and a second electrode, the first electrode, the organic deposition layer, and the second electrode being formed in this order, the method including:
   depositing the organic deposition layer so as to satisfy the relationship 0.093 < Ra/t < 0.340, where Ra denotes a surface roughness of a surface of the organic deposition layer, the surface being at the side of the second electrode, and t denotes a thickness of the organic deposition layer.

### Advantageous Effects of Invention

The present invention can provide an organic electroluminescent element having high interlayer adhesiveness and durability, and a method for producing the organic electroluminescent element.

### Brief Description of Drawings

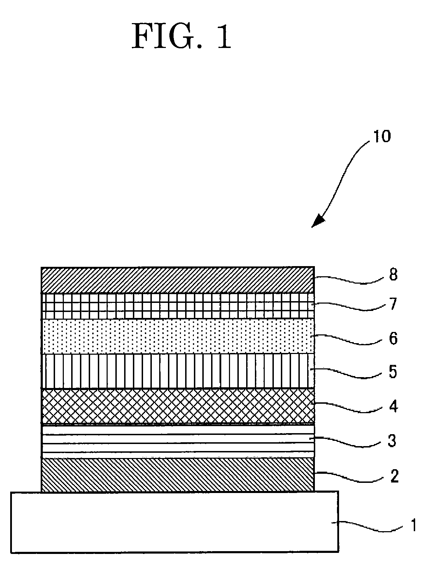

Fig. 1 is a cross-sectional view of one exemplary configuration of an organic electroluminescent element of the present invention.

### Description of Embodiments

### (Organic electroluminescent element)

An organic electroluminescent element of the present invention includes: a first electrode; at least one organic deposition layer; and a second electrode, the first electrode, the organic deposition layer, and the second electrode being formed in this order, wherein the organic deposition layer satisfies the relationship 0.093 <Ra/t < 0.340 where Ra denotes a surface roughness of a surface of the organic deposition layer, the surface being at the side of the second electrode, and t denotes a thickness of the organic deposition layer.

The ratio Ra/t is not particularly limited so long as it satisfies the relationship 0.093 < Ra/t < 0.340. From the viewpoint of producing an organic electroluminescent element having more excellent durability, it satisfies preferably 0.093 < Ra/t < 0.180, more preferably 0.099 < Ra/t < 0.115.

The surface roughness Ra is not particularly limited and may be appropriately selected depending on the intended purpose. It is preferably 0.270 nm to 1.800 nm, more preferably 0.270 nm to 1.100 nm, particularly preferably 0.295 nm to 0.350 nm.

When the surface roughness Ra is less than 0.270 nm, interlayer delamination easily occurs to degrade durability of the element. When it is more than 1.800 nm, leakage easily occurs to degrade reliability of the element.

The thickness t is not particularly limited and may be appropriately selected depending on the intended purpose. It is preferably 1 nm to 10 nm, more preferably 1 nm to 5 nm, particularly preferably 1 nm to 3 nm.

When the thickness t is smaller than 1 nm, sufficient adhesiveness cannot be obtained. When it is larger than 10 nm, the layer cannot satisfactorily adhere resulting in insufficient adhesiveness.

The measurement method of the surface roughness Ra or the thickness t is not particularly limited and may be various measurement methods. Examples thereof include: a method in which the cross-sectional surface is observed under a transmission electron microscope (TEM) or a scanning electron microscope (SEM); a method in which the height difference for surface roughness is measured with an atomic force microscope (AFM), a stylus profile meter, or an optical interference profiler; a method utilizing optical interference such as ellipsometry or X-ray reflectivity method; and elemental analysis using, for example, X-ray fluorescence (XRF).

The organic deposition layer having the above-defined Ra/t can be formed by performing deposition under appropriately set conditions of vacuum deposition.

The vacuum deposition conditions, including deposition rate, type of a deposition source container, deposition source temperature, substrate temperature, deposition source-substrate interdistance, angle formed between substrate surface and straight line connecting deposition source with substrate surface and degree of vacuum upon deposition, are not particularly limited and may be appropriately selected depending on the intended purpose.

Suitably employed deposition source containers are, for example, an alumina crucible, a silicon carbide crucible, a carbon crucible, and a tungsten board.

The deposition source temperature may be appropriately selected depending on the material of a luminescent film. The substrate temperature is preferably 25°C to 100°C.

The deposition source-substrate interdistance is preferably 5 cm to 40 cm.

The angle formed between the perpendicular line to the substrate surface and the straight line connecting the deposition source with the substrate surface is preferably 0° to 30°. The degree of vacuum upon deposition is preferably 1 × 10⁻² Pa to 3 × 10⁻⁸ Pa.

The deposition rate is not particularly limited and may be appropriately selected depending on the intended purpose. It is preferably 0.005 nm/sec to 0.300 nm/sec, more preferably 0.010 nm/sec to 0.150 nm/sec, particularly preferably 0.020 nm/sec to 0.080 nm/sec.

When the deposition rate is less than 0.005 nm/sec, the film formation becomes time-consuming, leading to a considerable drop in productivity. When it exceeds 0.300 nm/sec, it is difficult to keep the deposition rate constant, leading to a drop in yield.

The layer structure of the organic electroluminescent element is not particularly limited and may be appropriately selected depending on the intended purpose, so long as the organic electroluminescent element contains a first electrode, one organic deposition layer, and a second electrode which are formed in this order. Further, other components may be contained in the organic electroluminescent element.

The organic deposition layer is not particularly limited so long as it contains the luminescent layer, but preferably contains the luminescent layer, an adjacent layer to the luminescent layer, or both of them.

This layer structure improves the organic electroluminescent element in durability.

The adjacent layer as the organic deposition layer is preferably a hole transport layer.

Such structure is expected to improve the adhesiveness between the layers which can be most separated from each other, leading to improvement in durability.

The layers to be disposed between a first electrode and a second electrode include at least the luminescent layer, and further organic layers such as a hole injection layer, a hole transport layer, an electron transport layer, an electron injection layer, a hole blocking layer, and an electron blocking layer.

The organic layers are preferably formed by a vacuum deposition method. All of the organic layers do not have to be an organic deposition layer satisfying the above-defined relationship of Ra/t. One of the organic layers may be formed as the organic deposition layer, or two or more thereof may be formed as the organic deposition layer.

The structure of the organic layers is not particularly limited, but preferably a structure of the hole injection layer/the hole transport layer/the luminescent layer/the electron transport layer/the electron transport layer which are formed in this order on the first electrode.

The first electrode is preferably an anode and the second electrode is preferably a cathode.

### <Luminescent Layer>

The luminescent layer contains a hole transport host material and a phosphorescent material; and, if necessary, further contains other ingredients.

The host material is not particularly limited and may be appropriately selected depending on the intended purpose, but is preferably a hole transport host material.

### --Hole Transport Host Material--

The hole transport host material may be selected appropriately depending on the intended purpose, including, but not be particularly limited to, pyrrole, indole, carbazole, azaindole, azacarbazole, pyrazole, imidazole, polyarylalkane, pyrazoline, pyrazolone, phenylenediamine, arylamine, amino-substituted chalcone, styrylanthracene, fluorenone, hydrazone, stilbene, silazane; aromatic tertiary amine compounds; styrylamine compounds, aromatic dimethylidene compounds; porphyrin compounds; polysilane compounds; poly(N-vinyl carbazole); aniline copolymers; conductive polymers such as thiophene oligomers and polythiophenes; organic silane; carbon films; and derivatives thereof.

Among them, preferable are indole derivatives, carbazole derivatives, azaindole derivatives, azacarbazole derivatives, aromatic tertiary amine compounds and thiophene derivatives, and particularly preferable are compounds each having in the molecule a plurality of indole skeletons, azaindole skeletons, azacarbazole skeletons or aromatic tertiary amine skeletons.

Also, in the present invention, host materials part or all of the hydrogen atoms of which have been substituted by deuterium may be used (JP-A Nos. 2008-126130 and 2004-515506).

Specific compounds of such hole transport host materials include the following compounds but are not limited thereto.

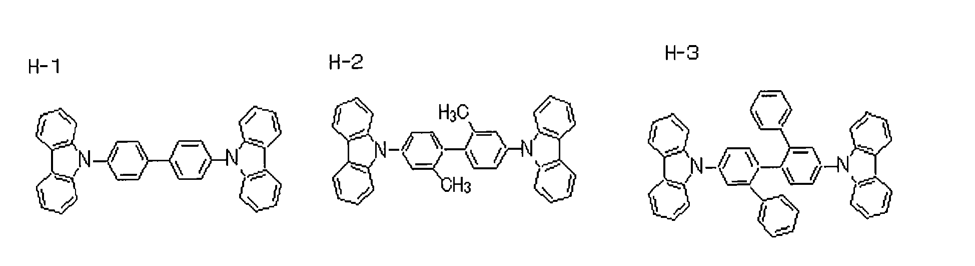

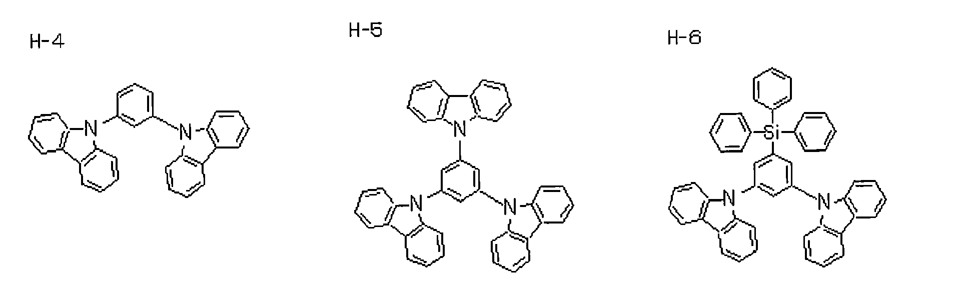

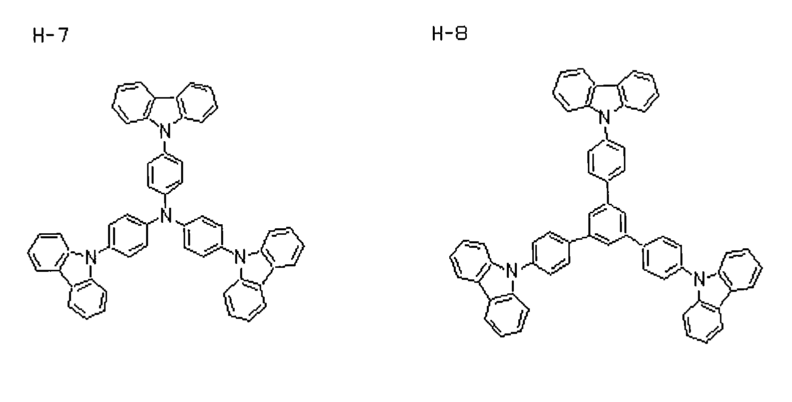

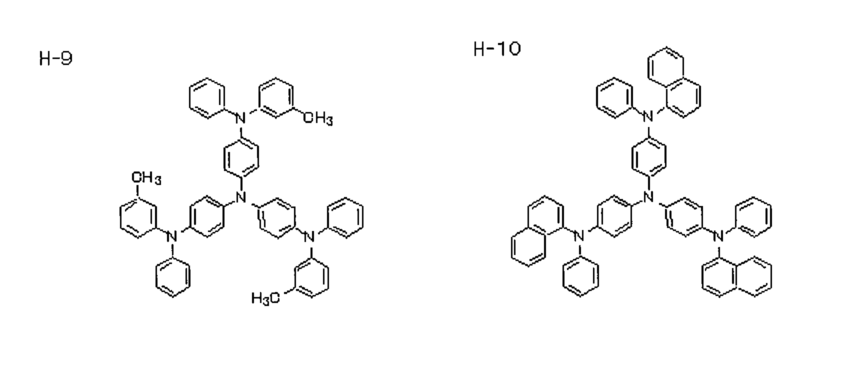

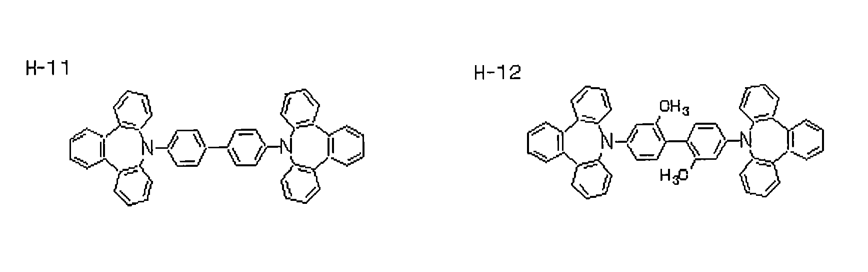

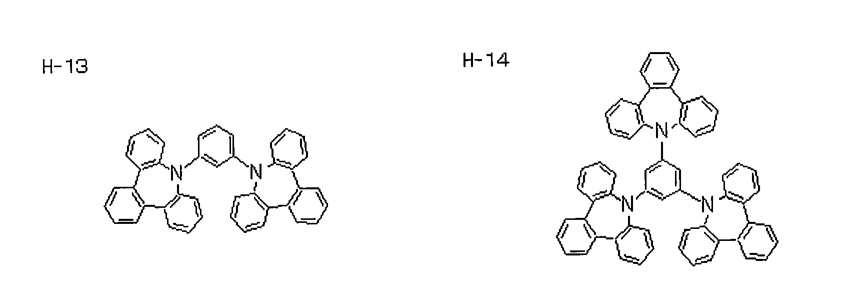

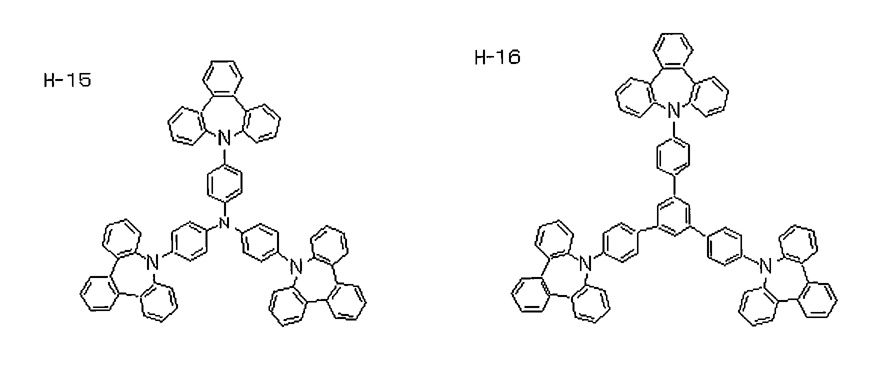

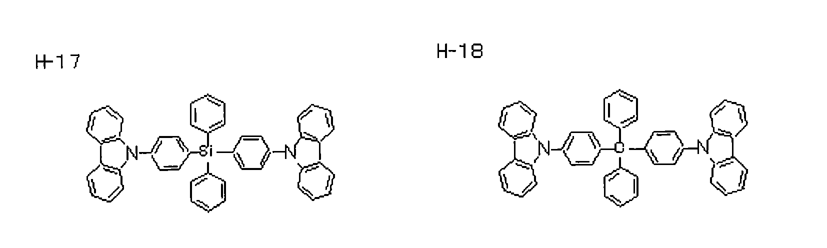

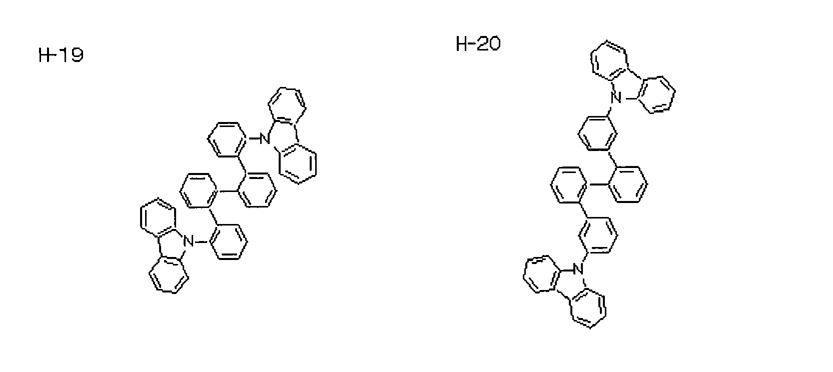

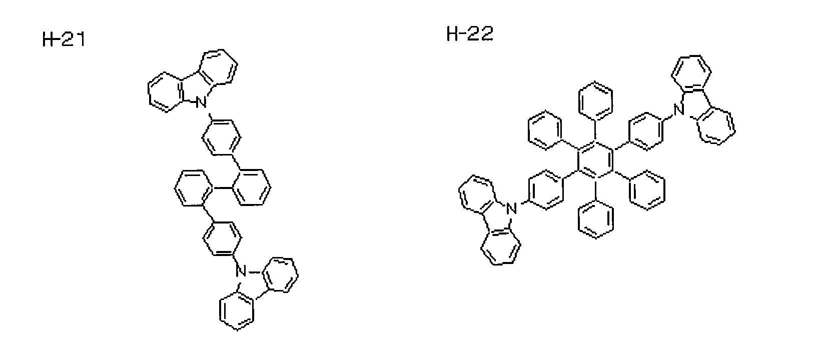

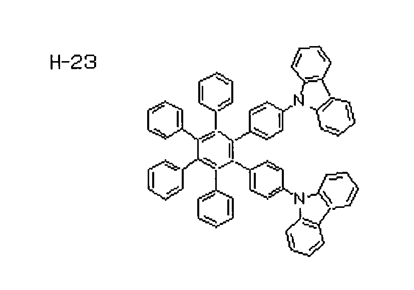

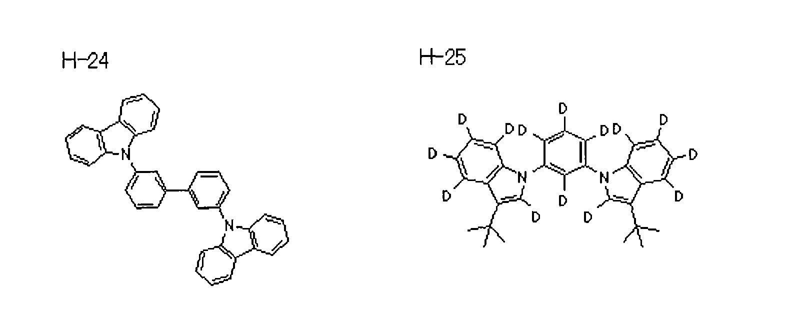

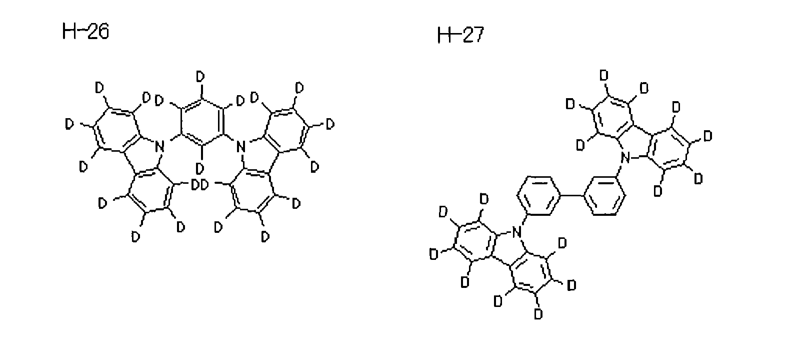

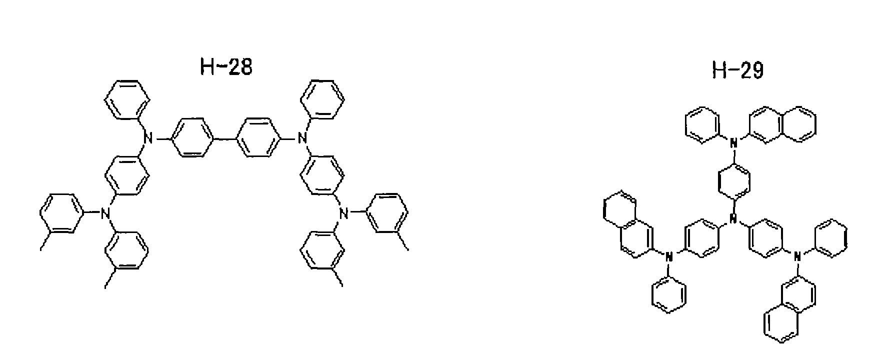

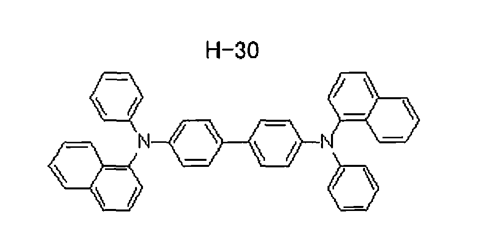

The content of the hole transport host material in the luminescent layer ranges preferably from 10% by mass to 99% by mass, more preferably 10% by mass to 90% by mass, still more preferably 20% by mass to 90% by mass, based on the total mass of the compounds which compose the luminescent layer.

### <Phosphorescent Material>

Examples of the phosphorescent material include a complex containing a transition metal atom or a lanthanoid atom. The transition metal atom may be, for example, ruthenium, rhodium, palladium, tungsten, rhenium, osmium, iridium, or platinum. Among them, more preferable are rhenium, iridium and platinum, and still more preferable are iridium and platinum.

Examples of the lanthanoid atom include lanthanum, cerium, praseodymium, neodymium, samarium, europium, gadolinium, terbium, dysprosium, holmium, erbium, thulium, ytterbium and lutetium, with neodymium, europium and gadolinium being preferred.

Examples of ligands in the complex include those described in, for example, "Comprehensive Coordination Chemistry" authored by G. Wilkinson et al., published by Pergamon Press Company in 1987; "Photochemistry and Photophysics of Coordination Compounds" authored by H. Yersin, published by Springer-Verlag Company in 1987; and "YUHKI KINZOKU KAGAKU-KISO TO OUYOU-(Metalorganic Chemistry-Fundamental and Application-)" authored by Akio Yamamoto, published by Shokabo Publishing Co., Ltd. in 1982.

Specific ligands are preferably halogen ligands (preferably, chlorine ligand), aromatic carbon ring ligands (e.g., cyclopentadienyl anion, benzene anion and naphthyl anion), nitrogen-containing hetero cyclic ligands (e.g., phenyl pyridine, benzoquinoline, quinolinol, bipyridyl and phenanthrorine), diketone ligands (e.g., acetyl acetone), carboxylic acid ligands (e.g., acetic acid ligand), alcoholate ligands (e.g., phenolate ligand), carbon monoxide ligand, isonitrile ligand, cyano ligand; and more preferably nitrogen-containing hetero cyclic ligands.

The above complexes may be a complex containing one transition metal atom in the compound, or a so-called polynuclear complex containing two or more transition metal atoms. In the latter case, the complexes may contain different metal atoms at the same time. Specific examples of the luminescent materials include the following compounds but are not limited thereto.

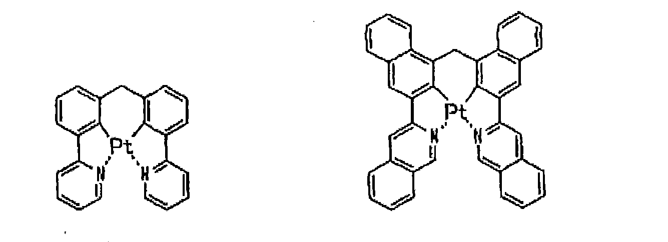

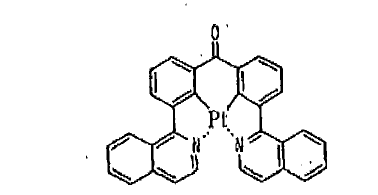

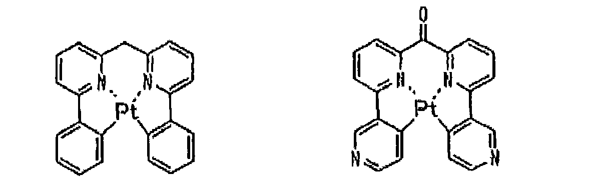

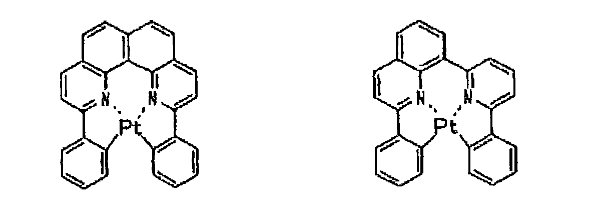

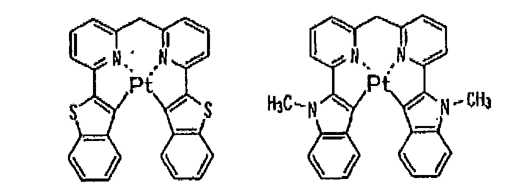

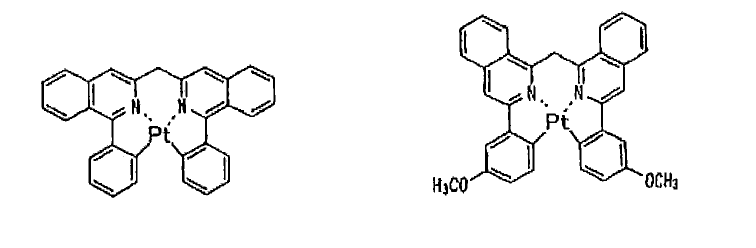

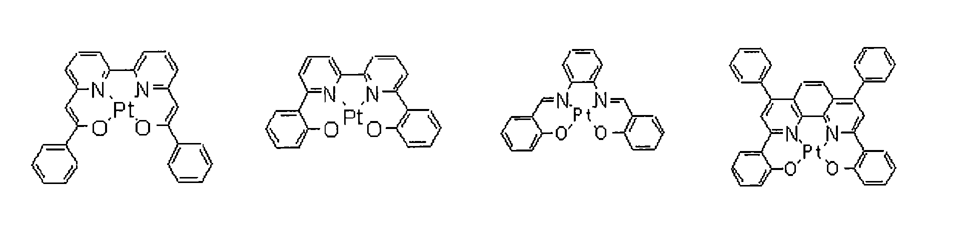

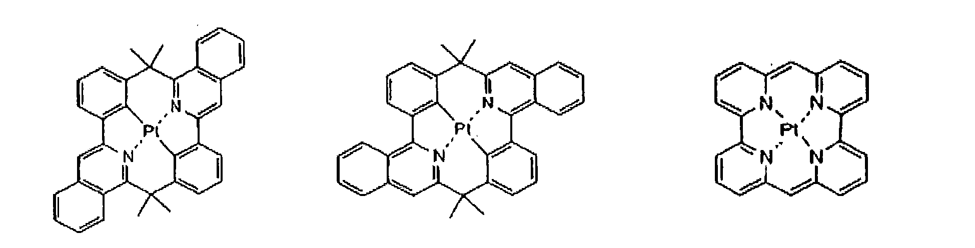

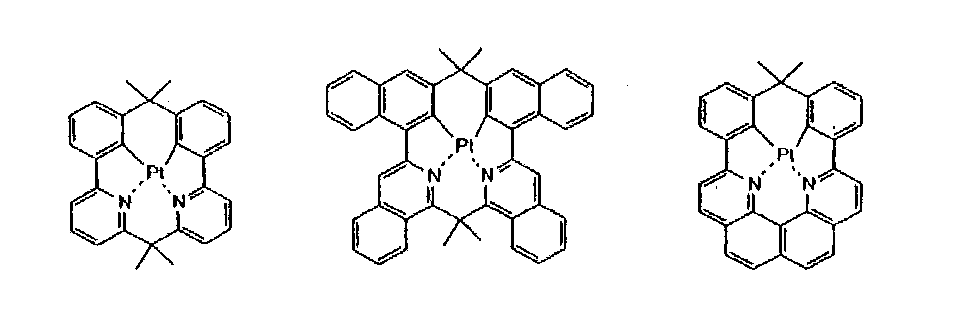

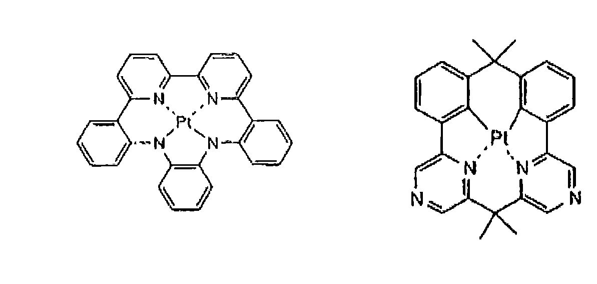

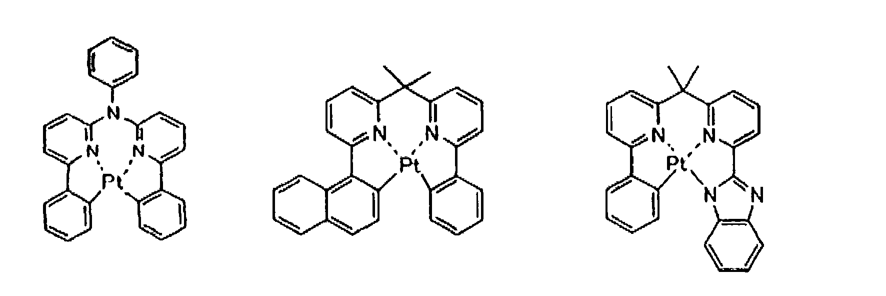

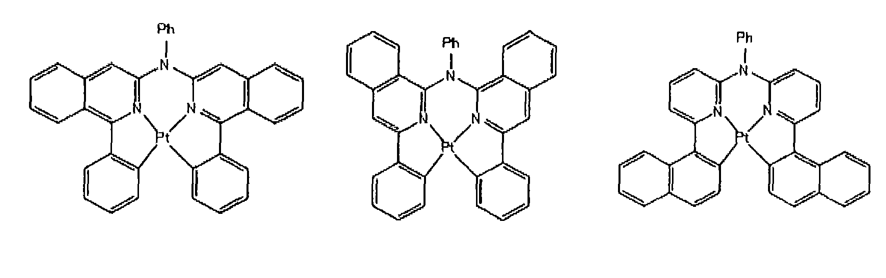

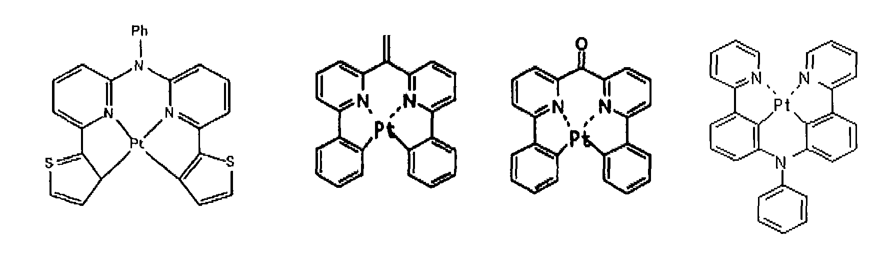

The phosphorescent material is not particularly limited and may be appropriately selected depending on the intended purpose. Preferred are compounds represented by the following General Formulas (1), (2) and (3).

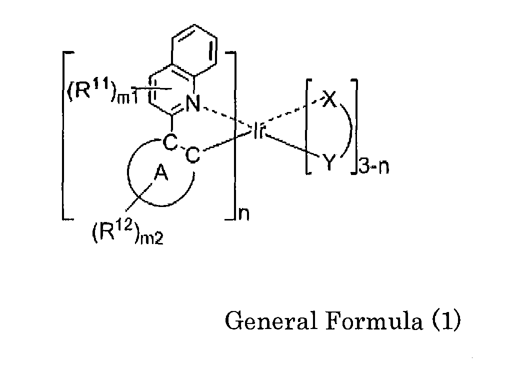

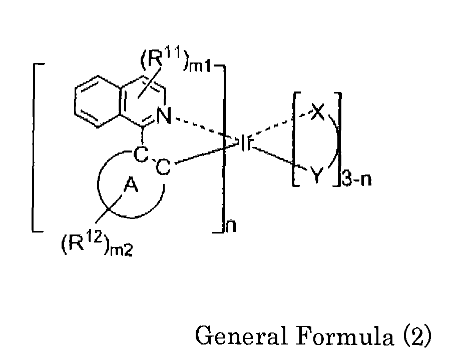

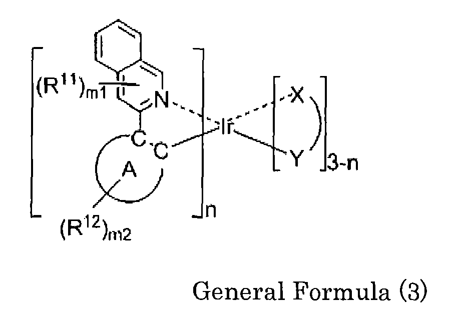

In General Formulas (1), (2) and (3), n is an integer of 1 to 3, X-Y denotes a bidentate ligand, A denotes a ring structure which may contain a nitrogen atom, a sulfur atom or an oxygen atom, R¹¹ represents a substituent, m1 is an integer of 0 to 6, when m1 is 2 or greater, the adjacent R¹¹s may be bonded to form a ring which may contain a nitrogen atom, a sulfur atom or an oxygen atom and which may have a substituent, R¹² represents a substituent, m2 is an integer of 0 to 4, when m2 is 2 or greater, the adjacent R¹²s may be bonded to form a ring which may contain a nitrogen atom, a sulfur atom or an oxygen atom and which may have a substituent, and R¹¹ and R¹² may be bonded to form a ring which may contain a nitrogen atom, a sulfur atom or an oxygen atom and which may have a substituent.

The ring A denotes a ring structure which may contain a nitrogen atom, a sulfur atom or an oxygen atom. Preferred examples of the ring structure include 5-membered and 6-membered rings. The ring may have a substituent.

X-Y denotes a bidentate ligand. Preferred examples thereof include bidentate monoanion ligands.

Examples of the bidentate monoanion ligands include picolinate (pic), acetylacetonato (acac) and dipyvaloylmethanato (t-butyl acac).

Examples of other ligands than the above ligands include ligands described on pp. 89 to 91 of International Publication No. WO02/15645 by Lamansky, et al.

The substituent represented by R¹¹ or R¹² is not particularly limited and may be appropriately selected depending on the intended purpose. Examples thereof include a halogen atom, an alkoxy group, an amino group, an alkyl group, a cycloalkyl group, an aryl group which may contain a nitrogen atom or a sulfur atom, an aryloxy group which may contain a nitrogen atom or a sulfur atom, each of the groups may further contain a substituent.

Regarding the groups represented by R¹¹ and R¹², the adjacent groups may be bonded to form a ring which may contain a nitrogen atom, a sulfur atom or an oxygen atom. Preferred examples of the ring include 5-membered and 6-membered rings. The ring may have a substituent.

Specific examples of the compounds represented by General Formulas (1), (2) and (3) include the following compounds but are not limited thereto.

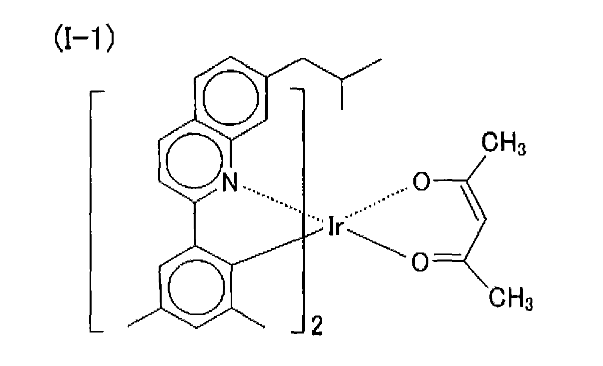

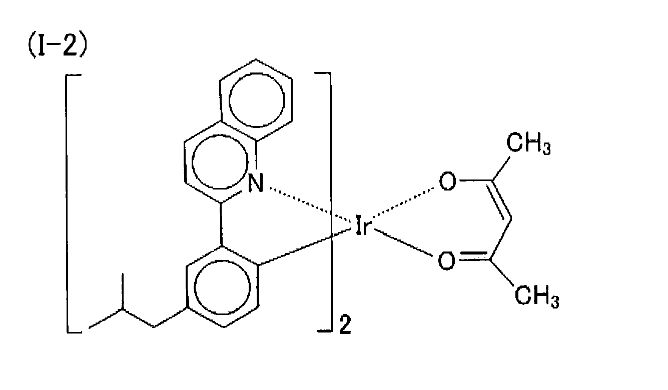

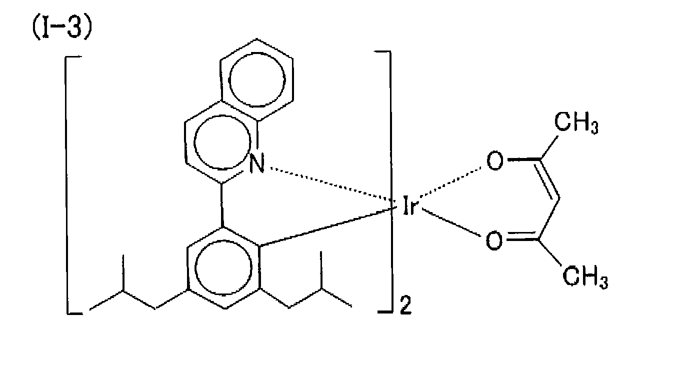

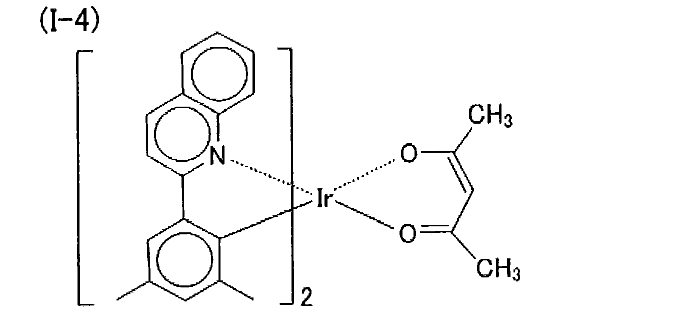

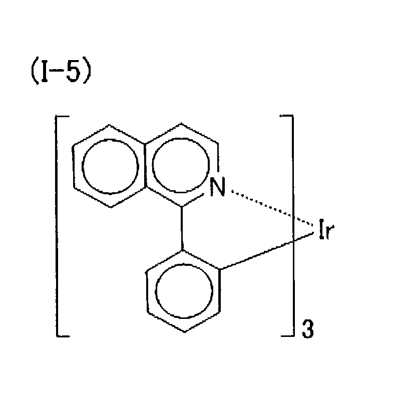

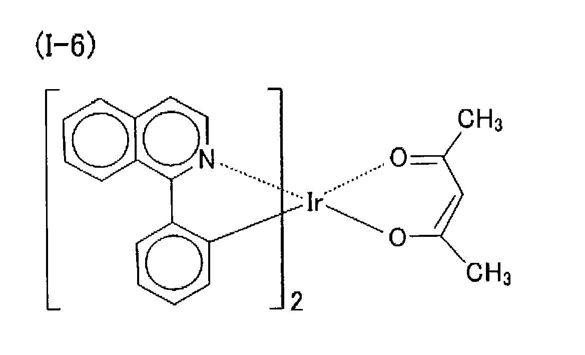

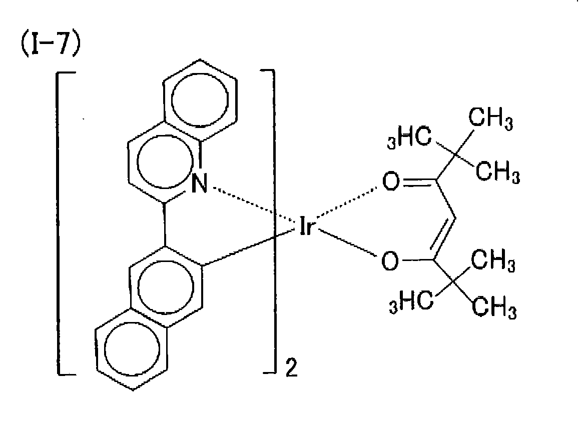

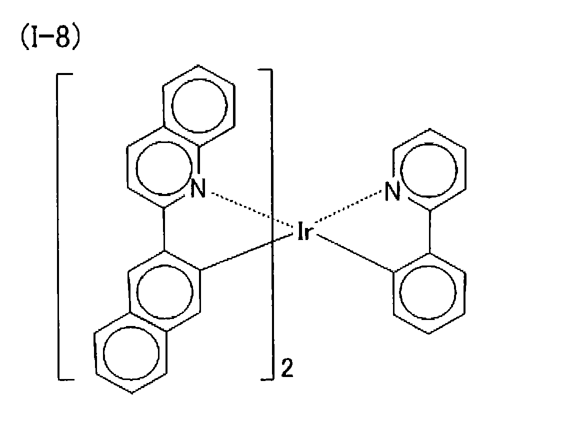

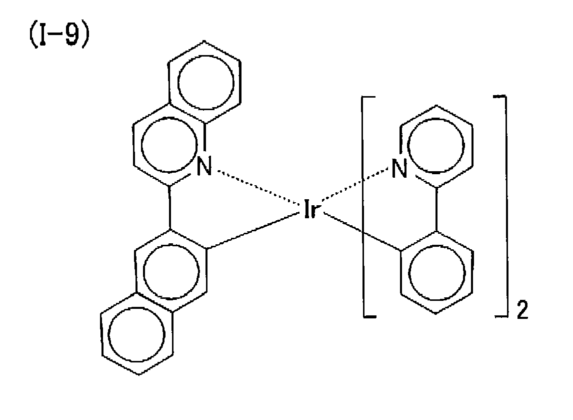

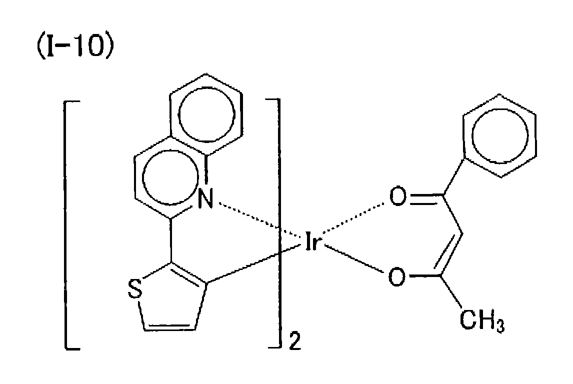

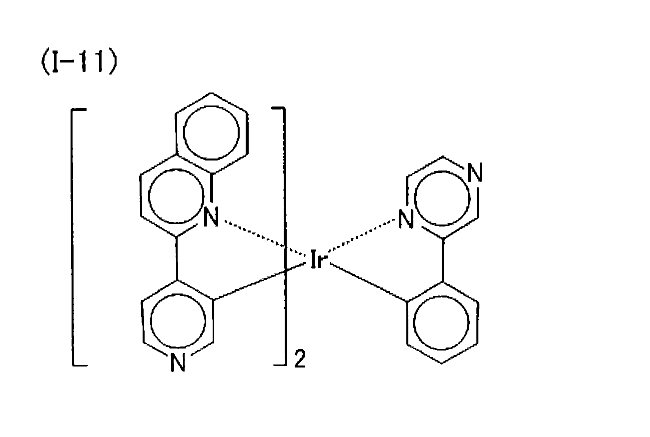

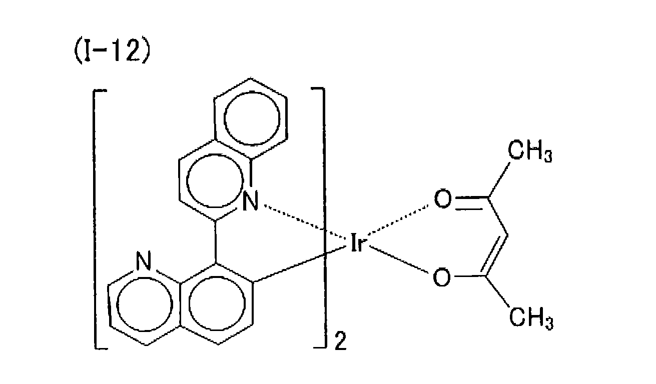

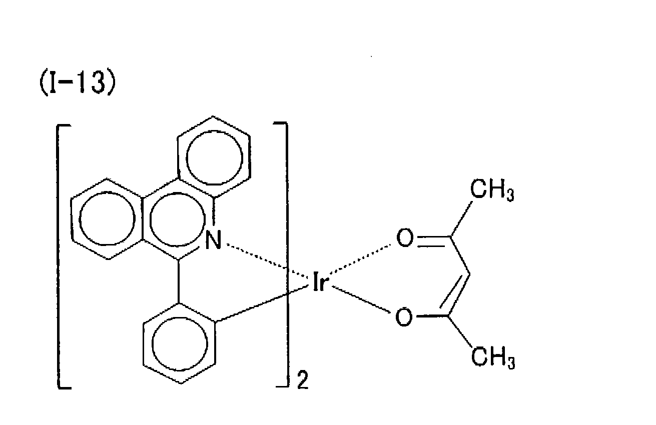

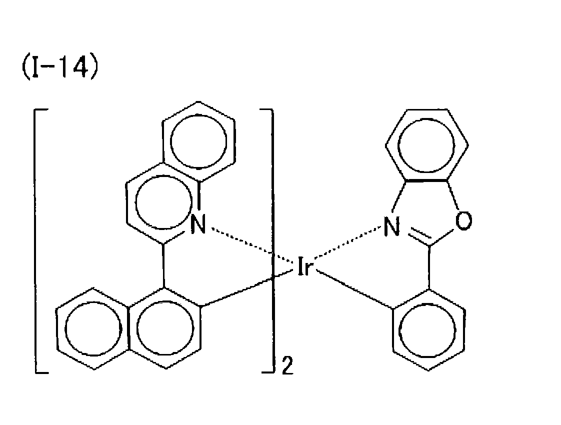

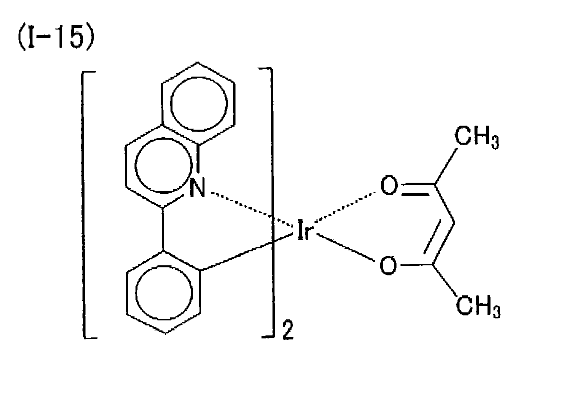

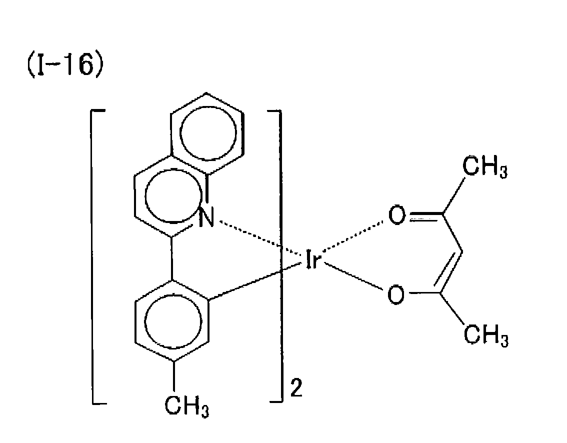

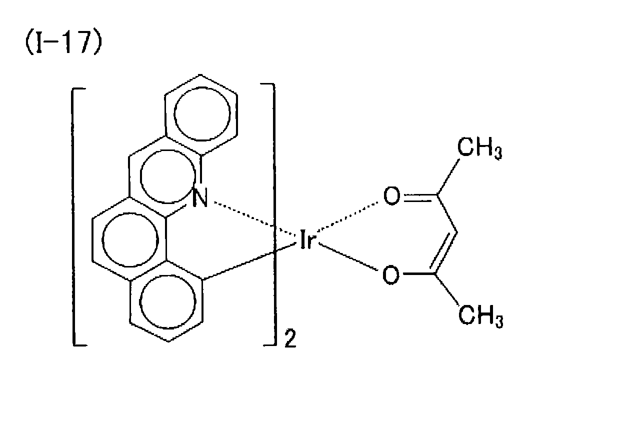

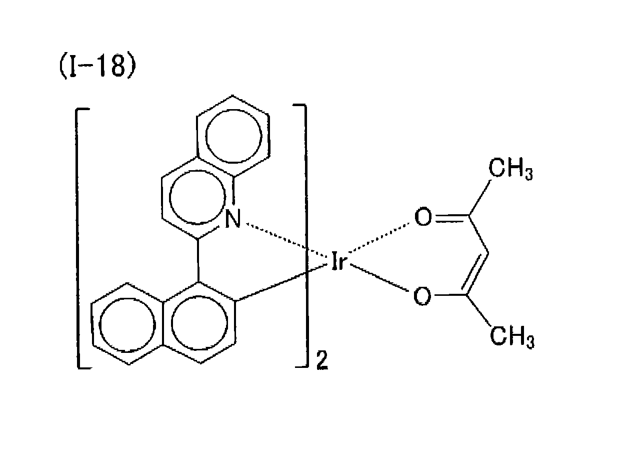

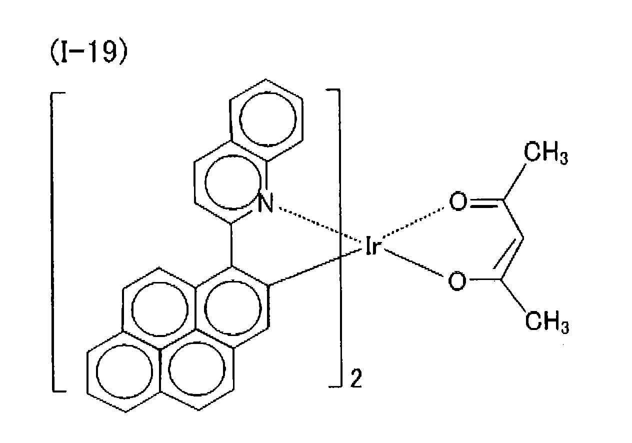

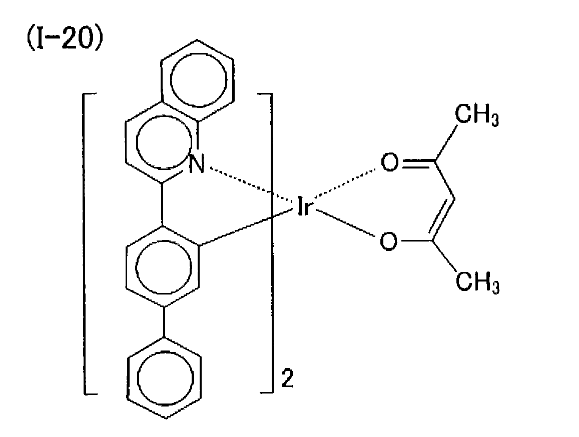

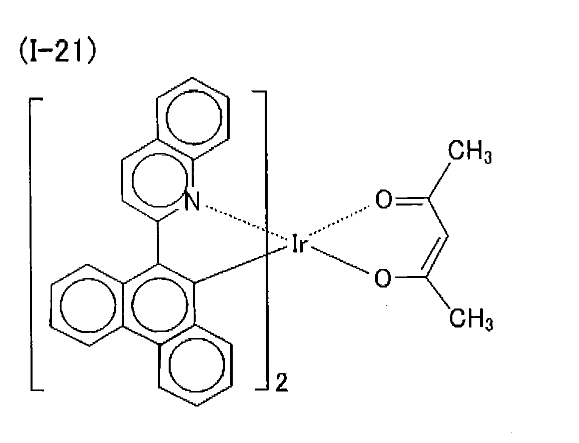

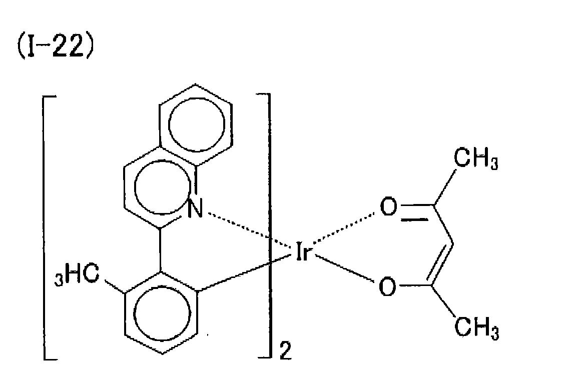

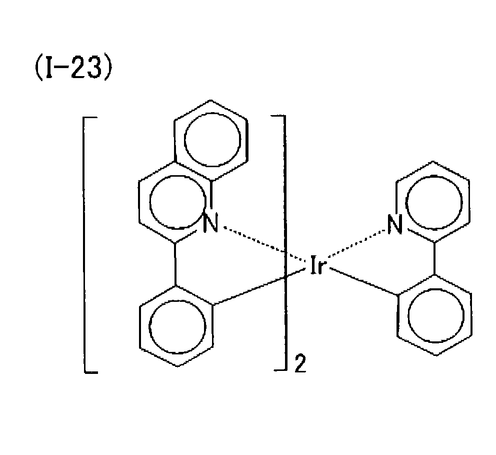

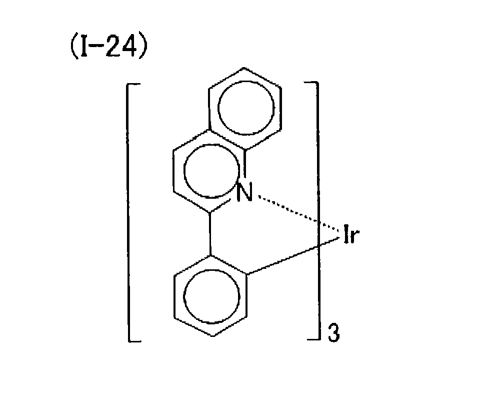

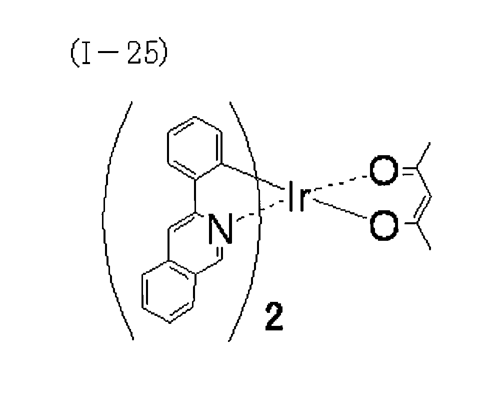

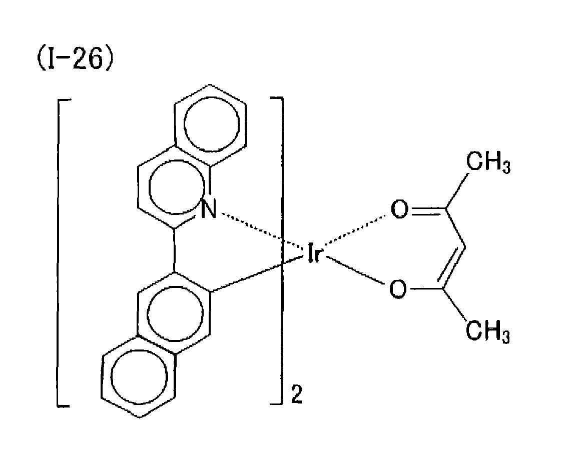

The content of the phosphorescent material in the luminescent layer ranges preferably from 0.5% by mass to 30% by mass, more preferably 0.5% by mass to 20% by mass, still more preferably 3% by mass to 10% by mass, based on the total mass of the compounds which compose the luminescent layer.

When the content of the phosphorescent material is less than 0.5% by mass, the luminescent efficiency may decrease. Whereas when it is more than 30% by mass, the phosphorescent materials may associate with each other to decrease the luminescent efficiency.

The luminescent layer is a layer having a function to accept a hole from an anode, a hole injection layer and a hole transport layer, while accepting an electron from a cathode, an electron injection layer and an electron transport layer, to provide a site to recombine the hole and the electron so as to emit light.

The thickness of the luminescent layer is not particularly limited and may be appropriately selected depending on the intended purpose. It is preferably 2 nm to 500 nm and, from the viewpoint of increasing the luminescent efficiency, is more preferably 3 nm to 200 nm, still more preferably 10 nm to 200 nm. The luminescent layer may be a single layer or two or more layers.

The organic electroluminescent element of the present invention includes: an anode; a cathode; and an organic layer containing a luminescent layer disposed between the anode and the cathode; and, if necessary, may further include other layers depending on the intended purpose.

The organic layer contains at least the luminescent layer; and, if necessary, may further contain, for example, an electron transport layer, an electron injection layer, a hole injection layer, a hole transport layer, a hole blocking layer and an electron blocking layer.

### <Hole Injection Layer and Hole Transport Layer>

The hole injection layer and the hole transport layer are layers having the function of receiving holes from the anode or from the anode side and transporting the holes to the cathode side. The hole injection layer and the hole transport layer may have a single-layered structure or a multi-layered structure made of a plurality of layers which are identical or different in composition.

Hole injection materials or hole transport materials used for these layers may be a low-molecular-weight compound or a high-molecular-weight compound.

Specifically, the hole injection materials or the hole transport materials are not particularly limited and may be appropriately selected depending on the intended purpose. Examples thereof include pyrrole derivatives, carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidine compounds, phthalocyanine compounds, porphyrin compounds, thiophene derivatives, organosilane derivatives and carbon. These may be used alone or in combination.

Specific compounds of the hole transport materials are not particularly limited and include the above specific compounds used as the hole transport host material.

In order to form the hole transport material into the organic deposition layer satisfying the above relationship of Ra/t, the following specific compounds are preferably used.

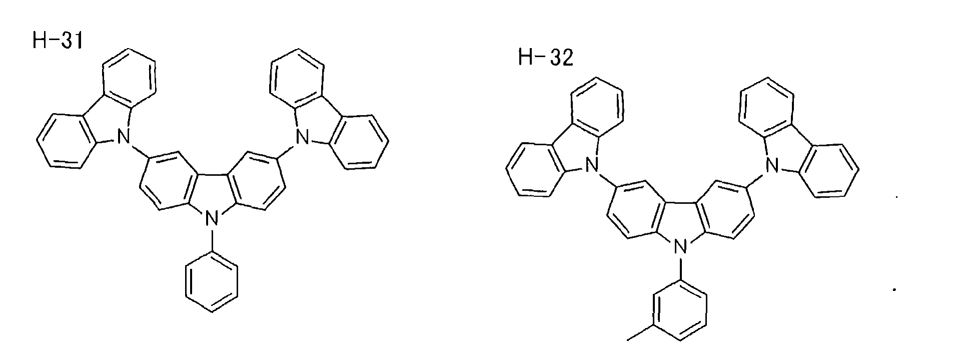

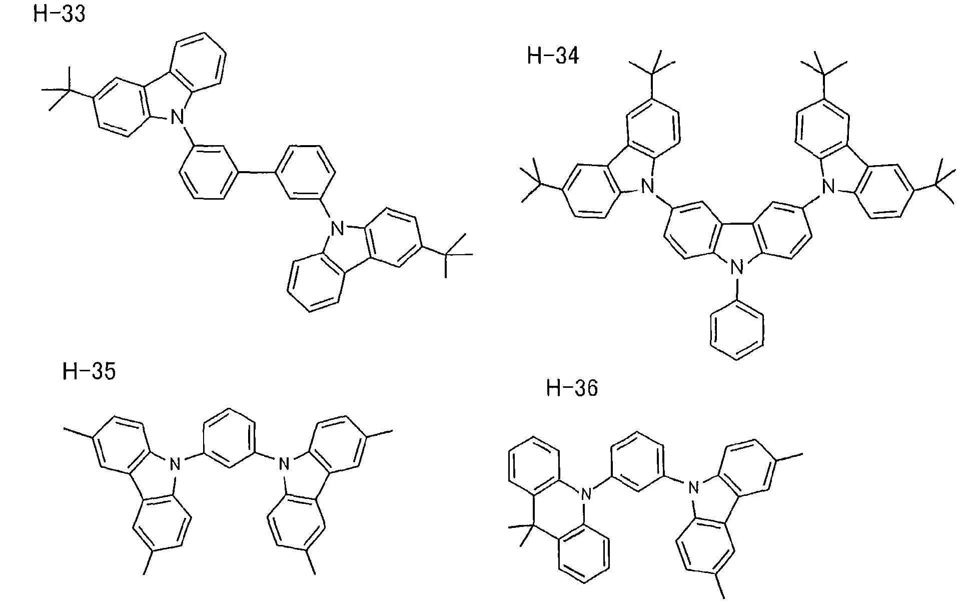

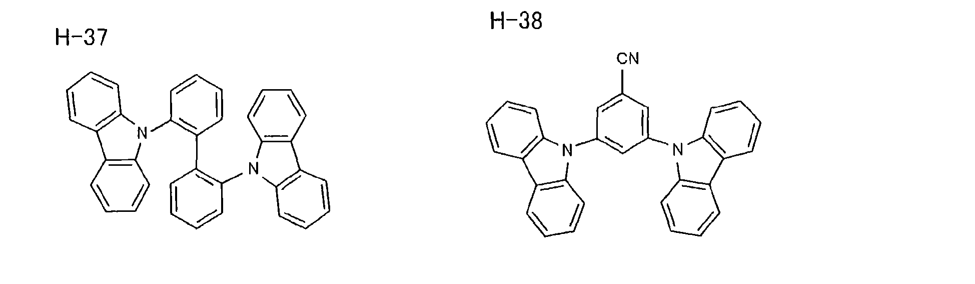

The hole injection layer or the hole transport layer may contain an electron accepting dopant.

The electron accepting dopant may be, for example, an inorganic or organic compound, so long as it has electron accepting property and the function of oxidizing an organic compound.

The inorganic compound is not particularly limited and may be appropriately selected depending on the intended purpose. Examples thereof include metal halides and metal oxides.

Examples of the metal halides include ferric chloride, aluminum chloride, gallium chloride, indium chloride and antimony pentachloride.

Examples of the metal oxides include vanadium pentaoxide and molybdenum trioxide.

The organic compound is not particularly limited and may be appropriately selected depending on the intended purpose. Examples thereof include compounds having a substituent such as a nitro group, a halogen, a cyano group and a trifluoromethyl group; quinone compounds; acid anhydride compounds; and fullerenes.

These electron accepting dopants may be used alone or in combination.

The amount of the electron accepting dopant used is not particularly limited and varies depending on the type of the material. The amount thereof is preferably 0.01% by mass to 50% by mass, more preferably 0.05% by mass to 30% by mass, particularly preferably 0.1% by mass to 30% by mass, relative to the hole transport material or the hole injection material.

The thickness of the hole injection layer or the hole transport layer is preferably 1 nm to 500 nm, more preferably 5 nm to 250 nm, further preferably 10 nm to 200 nm.

### <Electron Injection Layer and Electron Transport Layer>

The electron injection layer and the electron transport layer are layers having the functions of receiving electrons from the cathode or the cathode side and transporting the electrons to the anode side. The electron-injection materials or electron-transport materials for these layers may be low-molecular-weight or high-molecular-weight compounds.

Specific examples thereof include pyridine derivatives, quinoline derivatives, pyrimidine derivatives, pyrazine derivatives, phthalazine derivatives, phenanthoroline derivatives, triazine derivatives, triazole derivatives, oxazole derivatives, oxadiazole derivatives, imidazole derivatives, fluorenone derivatives, anthraquinodimethane derivatives, anthrone derivatives, diphenylquinone derivatives, thiopyrandioxide derivatives, carbodiimide derivatives, fluorenylidenemethane derivatives, distyrylpyradine derivatives, aryl tetracarboxylic anhydrides such as perylene and naphthalene, phthalocyanine derivatives, metal complexes (e.g., metal complexes of 8-quinolinol derivatives, metal phthalocyanine, and metal complexes containing benzoxazole or benzothiazole as the ligand) and organic silane derivatives (e.g., silole).

The electron-injection layer or the electron-transport layer may contain an electron donating dopant. The electron donating dopant to be introduced in the electron-injection layer or the electron-transport layer is not particularly limited, so long as it has an electron-donating property and a property for reducing an organic compound, and may be appropriately selected depending on the intended purpose. Preferred examples thereof include alkali metals (e.g., Li), alkaline earth metals (e.g., Mg), transition metals including rare-earth metals, and reducing organic compounds. Among the metals, those having a work function of 4.2 eV or less are particularly preferably used. Examples thereof include Li, Na, K, Be, Mg, Ca, Sr, Ba, Y, Cs, La, Sm, Gd and Yb. Also, examples of the reducing organic compounds include nitrogen-containing compounds, sulfur-containing compounds and phosphorus-containing compounds.

In addition, there may be used materials described in, for example, JP-A Nos. 06-212153, 2000-196140, 2003-68468, 2003-229278 and 2004-342614.

These electron donating dopants may be used alone or in combination. The amount of the electron donating dopant used depends on the type of the material, but it is preferably 0.1% by mass to 99% by mass, more preferably 1.0% by mass to 80% by mass, particularly preferably 2.0% by mass to 70% by mass, with respect to the amount of the material of the electron transport layer.

The thicknesses of the electron-injection layer and the electron-transport layer are each preferably 500 nm or less in terms of reducing drive voltage.

The thickness of the electron-transport layer is preferably 1 nm to 500 nm, more preferably 5 nm to 200 nm, still more preferably 10 nm to 100 nm. The thickness of the electron-injection layer is preferably 0.1 nm to 200 nm, more preferably 0.2 nm to 100 nm, still more preferably 0.5 nm to 50 nm.

Each of the electron-injection layer and the electron-transport layer may have a single-layered structure made of one or more of the above-mentioned materials, or a multi-layered structure made of a plurality of layers which are identical or different in composition.

### <Hole Blocking Layer and Electron Blocking Layer>

The hole blocking layer is a layer having the function of preventing the holes, which have been transported from the anode side to the luminescent layer, from passing toward the cathode side, and is generally provided as an organic compound layer adjacent to the luminescent layer on the cathode side.

The electron blocking layer is a layer having the function of preventing the electrons, which have been transported from the cathode side to the luminescent layer, from passing toward the anode side, and is generally provided as an organic compound layer adjacent to the luminescent layer on the anode side.

The compound forming the hole blocking layer is not particularly limited and may be appropriately selected depending on the intended purpose. Examples thereof include aluminum complexes (e.g., BAlq), triazole derivatives and phenanthroline derivatives (e.g., BCP).

Examples of the compound forming the electron blocking layer include those listed as a hole-transport material.

The thickness of the hole blocking layer or the electron blocking layer is preferably 1 nm to 200 nm, more preferably 1 nm to 50 nm, still more preferably 3 nm to 10 nm. The hole blocking layer or the electron blocking layer may have a single-layered structure made of one or more of the aforementioned materials, or a multi-layered structure made of a plurality of layers which are identical or different in composition.

### <Electrode>

The organic electroluminescent element of the present invention includes pair of electrodes; i.e., an anode and a cathode. In terms of the function of the organic electroluminescent element, at least one of the anode and the cathode is preferably transparent. In general, the anode may be any material, so long as it has the function of serving as an electrode which supplies holes to the organic compound layer.

The shape, structure, size, etc. thereof are not particularly limited and may be appropriately selected from known electrode materials depending on the intended application/purpose of the organic electroluminescent element.

Preferred examples of the material for the electrodes include metals, alloys, metal oxides, conductive compounds and mixtures thereof.

### -Anode-

The material for the anode is, for example, conductive metal oxides, metals, mixtures or laminates of these metals and the conductive metal oxides, inorganic conductive materials, organic conductive materials and laminates of these materials and ITO.

Examples of the conductive metal oxides include tin oxides doped with, for example, antimony and fluorine (ATO and FTO), tin oxide, zinc oxide, indium oxide, indium tin oxide (ITO) and indium zinc oxide (IZO).

Examples of the metals include gold, silver, chromium and nickel.

Examples of the inorganic conductive materials include copper iodide and copper sulfide.

Examples of the organic conductive materials include polyaniline, polythiophene and polypyrrole. Among them, conductive metal oxides are preferred. In particular, ITO is preferred from the viewpoints of productivity, high conductivity and transparency.

### -Cathode-

The material for the cathode is, for example, alkali metals (e.g., Li, Na, K and Cs), alkaline earth metals (e.g., Mg and Ca), gold, silver, lead, aluminum, sodium-potassium alloys, lithium-aluminum alloys, magnesium-silver alloys and rare earth metals (e.g., indium and ytterbium). These may be used alone, but it is preferred that two or more of them are used in combination from the viewpoint of satisfying both stability and electron-injection property.

Among them, as the materials for forming the cathode, alkali metals or alkaline earth metals are preferred in terms of excellent electron-injection property, and materials containing aluminum as a major component are preferred in terms of excellent storage stability.

The term "material containing aluminum as a major component" refers to a material composed of aluminum alone; alloys containing aluminum and 0.01% by mass to 10% by mass of an alkali or alkaline earth metal; or the mixtures thereof (e.g., lithium-aluminum alloys and magnesium-aluminum alloys).

The method for forming the electrodes is not particularly limited and may be a known method. Examples thereof include vacuum deposition methods.

### <Substrate>

The organic electroluminescent element of the present invention is preferably formed on a substrate, may be formed so that a substrate comes into direct contact with the electrodes, or may be formed on a substrate by the mediation of an intermediate layer.

The material for the substrate is not particularly limited and may be appropriately selected depending on the intended purpose. Examples thereof include inorganic materials, polyesters and organic materials.

Examples of the inorganic materials include yttria-stabilized zirconia (YSZ) and glass (e.g., alkali-free glass and soda-lime glass).

Examples of the polyesters include polyethylene terephthalate, polybutylene phthalate and polyethylene naphthalate.

Examples of the organic materials include polystyrene, polycarbonate, polyether sulfone, polyarylate, polyimide, polycycloolefin, norbornene resins and poly(chlorotrifluoroethylene).

The shape, structure, size, etc. of the substrate are not particularly limited and may be appropriately selected depending on, for example, the intended application/purpose of the light-emitting device. In general, the substrate is preferably a sheet. The substrate may have a single- or multi-layered structure, and may be a single member or a combination of two or more members. The substrate may be opaque, colorless transparent, or colored transparent.

The substrate may be provided with a moisture permeation-preventing layer (gas barrier layer) on the front or back surface thereof.

The moisture permeation-preventing layer (gas barrier layer) is preferably made from an inorganic compound such as silicon nitride and silicon oxide.

The moisture permeation-preventing layer (gas barrier layer) may be formed through, for example, high-frequency sputtering.

### -Other Components-

The other components are not particularly limited and may be appropriately selected depending on the intended purpose. Examples thereof include a protective layer, a sealing container, a resin seal layer and a sealing adhesive.

The type of the protective layer, the sealing container, the resin seal layer or the sealing adhesive is not particularly limited and may be appropriately selected depending on the intended purpose. The description of JP-A No. 2009-152572 and other literatures can be applied thereto.

Fig. 1 is a schematic view of one exemplary layer structure of the organic electroluminescent element of the present invention. An organic electroluminescent element 10 has a layer structure in which a glass substrate 1 and an anode 2 (e.g., an ITO electrode), a hole injection layer 3, a hole transport layer 4, a luminescent layer 5, an electron transport layer 6, an electron injection layer 7, a cathode 8 (e.g., anAl-Li electrode) disposed on the glass substrate 1 in this order. Notably, the anode 2 (e.g., the ITO electrode) and the cathode 8 (e.g., the Al-Li electrode) are connected together via a power source.

### -Driving

The organic electroluminescent element can emit light when a DC voltage (which, if necessary, contains AC components) (generally 2 volts to 15 volts) or a DC is applied to between the anode and the cathode.

The organic electroluminescent element of the present invention can be applied to an active matrix using a thin film transistor (TFT). An active layer of the thin film transistor may be made from, for example, amorphous silicon, high-temperature polysilicon, low-temperature polysilicon, microcrystalline silicon, oxide semiconductor, organic semiconductor and carbon nanotube.

The thin film transistor used for the organic electroluminescent element of the present invention may be those described in, for example, International Publication No. WO2005/088726, JP-A No. 2006-165529 and U.S. Pat. Application Publication No. 2008/0237598.

The organic electroluminescent element of the present invention is not particularly limited. In the organic electroluminescent element, the light-extraction efficiency can be further improved by various known methods. It is possible to increase the light-extraction efficiency to improve the external quantum efficiency, for example, by processing the surface shape of the substrate (for example, by forming a fine concavo-convex pattern), by controlling the refractive index of the substrate, the ITO layer and/or the organic layer, or by controlling the thickness of the substrate, the ITO layer and/or the organic layer.

The manner in which light is extracted from the organic electroluminescent element of the present invention may be top-emission or bottom-emission.

The organic electroluminescent element may have a resonator structure. For example, on a transparent substrate are stacked a multi-layered film mirror composed of a plurality of laminated films having different refractive indices, a transparent or semi-transparent electrode, a luminescent layer and a metal electrode. The light generated in the luminescent layer is repeatedly reflected between the multi-layered film mirror and the metal electrode (which serve as reflection plates); i.e., is resonated.

In another embodiment, a transparent or semi-transparent electrode and a metal electrode are stacked on a transparent substrate. In this structure, the light generated in the luminescent layer is repeatedly reflected between the transparent or semi-transparent electrode and the metal electrode (which serve as reflection plates); i.e., is resonated.

For forming the resonance structure, an optical path length determined based on the effective refractive index of two reflection plates, and on the refractive index and the thickness of each of the layers between the reflection plates is adjusted to be an optimal value for obtaining a desired resonance wavelength.

The calculation formula applied in the case of the first embodiment is described in JP-A No. 09-180883. The calculation formula in the case of the second embodiment is described in JP-A No. 2004-127795.

### -Application-

The application of the organic electroluminescent element of the present invention is not particularly limited and may be appropriately selected depending on the intended purpose. The organic electroluminescent element can be suitably used in, for example, display devices, displays, backlights, electrophotography, illuminating light sources, recording light sources, exposing light sources, reading light sources, markers, interior accessories and optical communication.

As a method for forming a full color-type display, there are known, for example, as described in "Monthly Display," September 2000, pp. 33 to 37, a tricolor light emission method by arranging, on a substrate, organic electroluminescent elements corresponding to three primary colors (blue color (B), green color (G) and red color (R)); a white color method by separating white light emitted from an organic electroluminescent element for white color emission into three primary colors through a color filter; and a color conversion method by converting a blue light emitted from an organic electroluminescent element for blue light emission into red color (R) and green color (G) through a fluorescent dye layer.

### (Method for Producing Organic Electroluminescent Element)

A method of the present invention for producing an organic electroluminescent element including a first electrode, at least one organic deposition layer containing a luminescent layer, and a second electrode which are formed in this order, includes a step of depositing the organic deposition layer so as to satisfy the following relationship: 0.093 < Ra/t < 0.340, where Ra denotes a surface roughness of a surface of the organic deposition layer, the surface being at the side of the second electrode, and t denotes a thickness of the organic deposition layer; and, if necessary, further includes other steps.

Any matter described above regarding the organic electroluminescent element of the present invention can be applied to: the organic electroluminescent element including a first electrode, at least one organic deposition layer containing a luminescent layer, and a second electrode which are formed in this order; the organic deposition layer satisfying the following relationship: 0.093 < Ra/t < 0.340, where Ra denotes a surface roughness of a surface of the organic deposition layer, the surface being at the side of the second electrode, and t denotes a thickness of the organic deposition layer; and the specific deposition method.

The other steps are not particularly limited and may be appropriately selected depending on the intended purpose. For example, any known matter can be applied to the method for producing an organic electroluminescent element.

### Examples

The present invention will next be described in detail by way of Examples, which should not be construed as limiting the present invention thereto.

### (Example 1)

A glass substrate, 0.5 mm thickness and 2.5 cm × 2.5 cm, was placed in a washing case, where it was ultrasonically washed in 2-propanol. The thus-washed glass substrate was subjected to UV-ozone treatment for 30 minutes. Onto the resulting glass substrate, each layer described below was deposited by the vacuum deposition method.

The deposition was conducted using a vacuum deposition apparatus (product of Tokki Corporation) and, unless otherwise specified, the deposition rate was 0.2 nm/s. The deposition rate and the thickness of each layer were determined by measuring, using a film thickness monitor (CRTM-9000, product of Ulvac, Inc.), the deposition rate of the deposition material on a crystal oscillator located distant by the same distance as that between the deposition source and the substrate.

Also, the surface roughness Ra of the deposition layer was an average of five measurements which were obtained by measuring a 2 µm × 2 µm measurement region five times on a tapping mode using an atomic force microscope (AFM, product of KEYENCE CORPORATION, VN-8000).

Onto the glass substrate, ITO (Indium Tin Oxide) was deposited to have a thickness of 100 nm.

On the anode, 2-TNATA (4,4',4"-Tris(N-(2-naphthyl)-N-phenyl-amino)-triphenylamine) was deposited to form a hole injection layer having a thickness of 40 nm.

On the hole injection layer, α-NPD (bis[N-(1-naphthyl)-N-phenyl]benzidine) was deposited to form a first hole transport layer having a thickness of 7 nm.

On the first hole transport layer, the following hole transport material 1 was deposited at a deposition rate of 0.05 nm/sec so as to have the intended surface roughness, to form a second hole transport layer having a thickness of 3 nm.

On the second hole transport layer, the following host material 1 and the following phosphorescent material 1 were deposited to have a thickness of 30 nm, to form a luminescent layer in which the host material 1 was doped with the phosphorescent material in an amount of 15% by mass.

Notably, the surface roughness Ra of the second hole transport layer facing a luminescent layer to be formed was measured using an atomic force microscope (AFM) and a measurement sample produced in the above-described manner to have a second hole transport layer as the last layer.

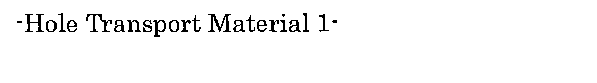

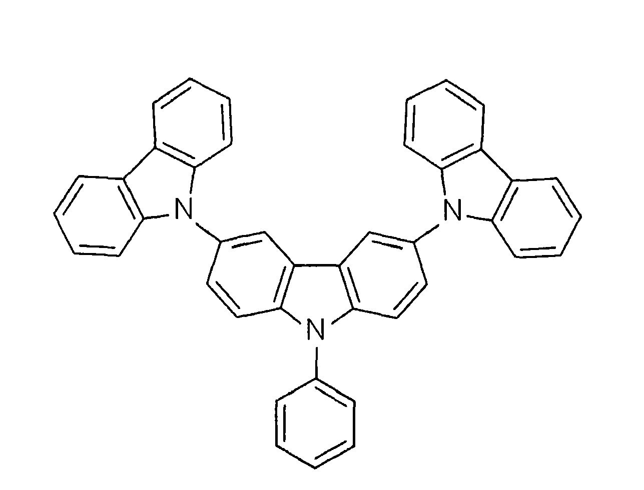

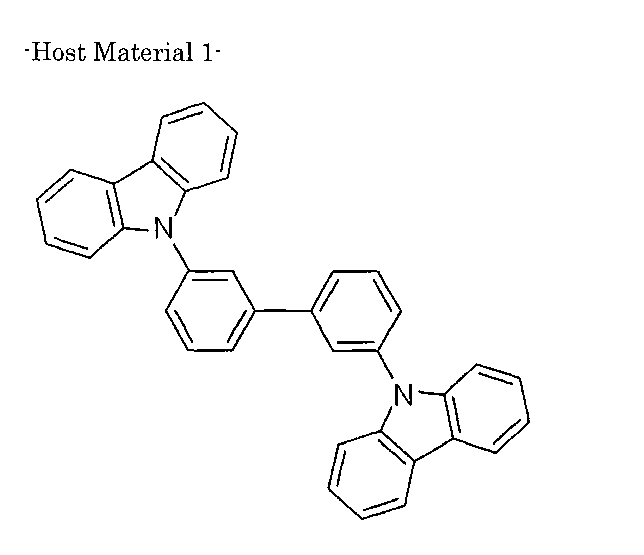

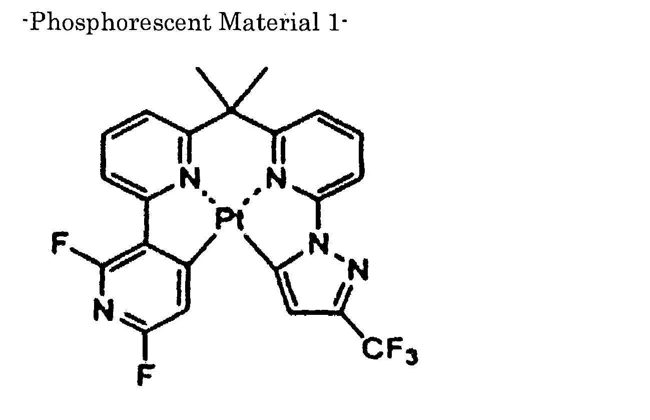

BAlq (bis-(2-methyl-8-quinolinolato)-4-(phenyl)-phenolate-aluminium(III)) was deposited on the luminescent layer so as to have a thickness of 30 nm, to thereby form a first electron transport layer.

LiF was deposited on the first electron transport layer so as to have a thickness of 1 nm, to thereby form a second electron transport layer.

On the second electron transport layer, a mask patterned (giving a luminescent region of 2 mm × 2 mm) was placed before depositing metal aluminum to attain a thickness of 70 nm to form a cathode.

The thus-produced laminate was placed in a glove box purged with argon gas and then sealed using a glass seal can and a UV curable sealant (XNR5516HV, Nagase-Ciba Ltd.) Through the above procedure, an organic electroluminescent element of Example 1 was produced.

### (Example 2)

An organic electroluminescent element of Example 2 was produced in the same manner as in Example 1, except that the following hole transport material 2 was used instead of the hole transport material 1 to form the second hole transport layer.

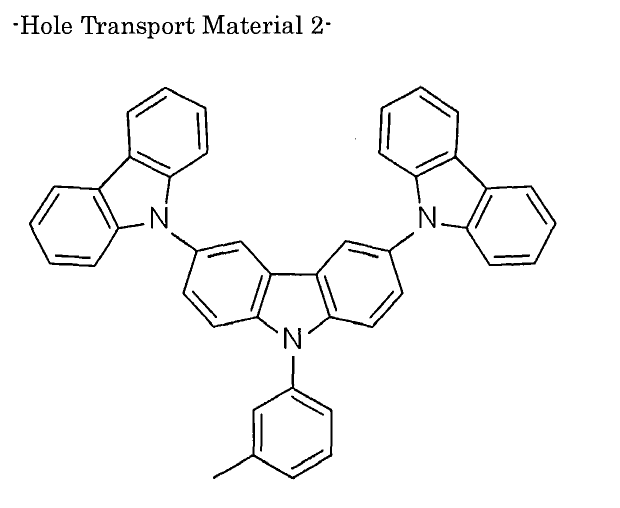

### (Example 3)

An organic electroluminescent element of Example 3 was produced in the same manner as in Example 1, except that the following hole transport material 3 was used instead of the hole transport material 1 to form the second hole transport layer.

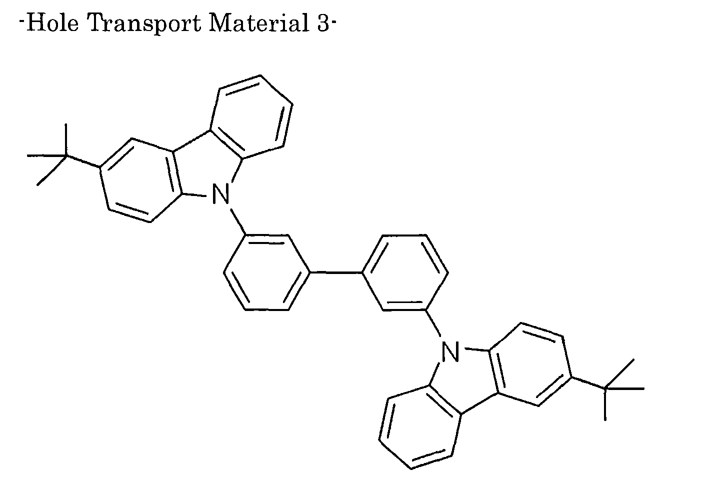

### (Example 4)

An organic electroluminescent element of Example 4 was produced in the same manner as in Example 1, except that the following hole transport material 4 was used instead of the hole transport material 1 to form the second hole transport layer.

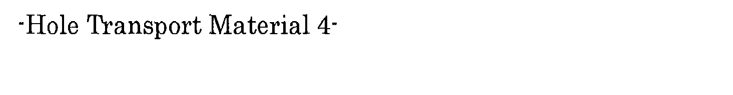

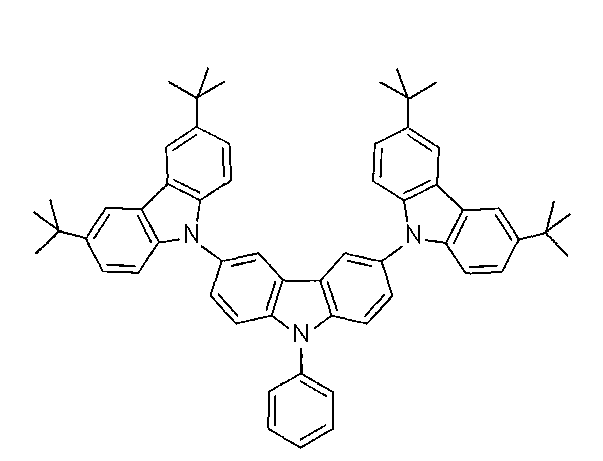

### (Comparative Example 1)

An organic electroluminescent element of Comparative Example 1 was produced in the same manner as in Example 1, except that the following hole transport material 5 was used instead of the hole transport material 1 to form the second hole transport layer.

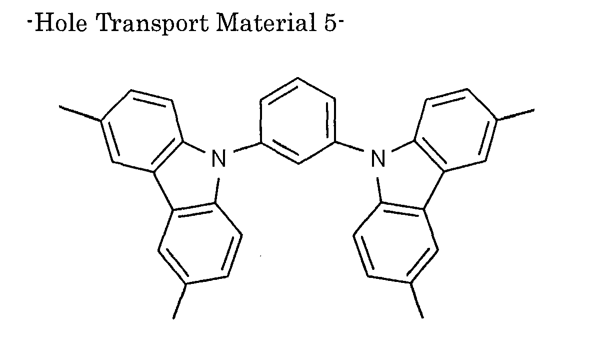

### (Comparative Example 2)

An organic electroluminescent element of Comparative Example 2 was produced in the same manner as in Example 1, except that the following hole transport material 6 was used instead of the hole transport material 1 to form the second hole transport layer.

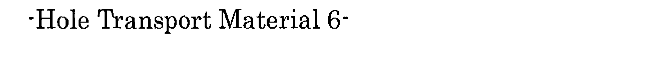

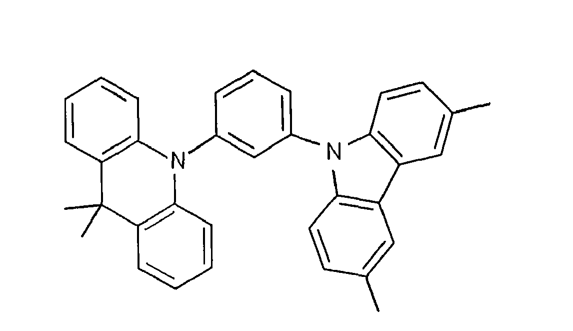

### (Comparative Example 3)

An organic electroluminescent element of Comparative Example 3 was produced in the same manner as in Example 1, except that the following hole transport material 7 was used instead of the hole transport material 1 to form the second hole transport layer.

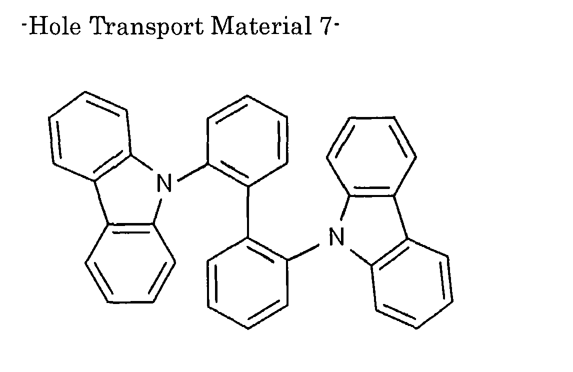

### (Comparative Example 4)

An organic electroluminescent element of Comparative Example 4 was produced in the same manner as in Example 1, except that the following hole transport material 8 was used instead of the hole transport material 1 to form the second hole transport layer.

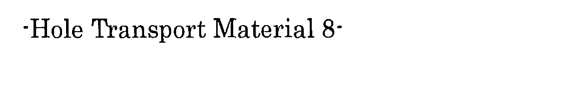

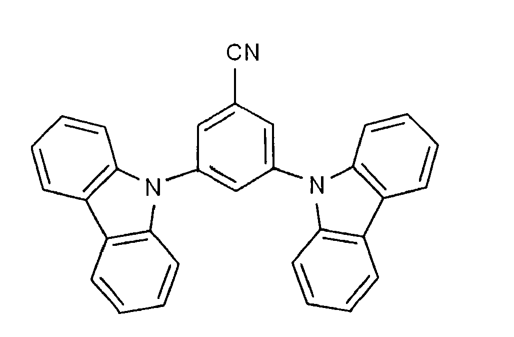

### (Comparative Example 5)

An organic electroluminescent element of Comparative Example 5 was produced in the same manner as in Example 1, except that the deposition rate of the hole transport material 1 was changed from 0.05 nm/sec to 0.005 nm/sec.

### (Comparative Example 6)

An organic electroluminescent element of Comparative Example 6 was produced in the same manner as in Example 1, except that the deposition rate of the hole transport material 1 was changed from 0.05 nm/sec to 0.01 nm/sec.

### (Comparative Example 7)

An organic electroluminescent element of Comparative Example 7 was produced in the same manner as in Example 1, except that the deposition rate of the hole transport material 1 was changed from 0.05 nm/sec to 0.25 nm/sec.

### (Example 5)

An organic electroluminescent element of Example 5 was produced in the same manner as in Example 1, except that the deposition rate of the hole transport material 1 was changed from 0.05 nm/sec to 0.25 nm/sec and that the thickness of the second hole transport layer was changed from 3 nm to 10 nm.

### (Example 6)

An organic electroluminescent element of Example 6 was produced in the same manner as in Example 2, except that the deposition rate of the hole transport material 2 was changed from 0.05 nm/sec to 0.25 nm/sec and that the thickness of the second hole transport layer was changed from 3 nm to 10 nm.

### (Example 7)

An organic electroluminescent element of Example 7 was produced in the same manner as in Comparative Example 3, except that the deposition rate of the hole transport material 7 was changed from 0.05 nm/sec to 0.25 nm/sec and that the thickness of the second hole transport layer was changed from 3 nm to 1 nm.

### (Comparative Example 8)

An organic electroluminescent element of Comparative Example 8 was produced in the same manner as in Comparative Example 1, except that the deposition rate of the hole transport material 5 was changed from 0.05 nm/sec to 0.025 nm/sec and that the thickness of the second hole transport layer was changed from 3 nm to 10 nm.

### (Comparative Example 9)

An organic electroluminescent element of Comparative Example 9 was produced in the same manner as in Comparative Example 3, except that the deposition rate of the hole transport material 7 was changed from 0.05 nm/sec to 0.025 nm/sec and that the thickness of the second hole transport layer was changed from 3 nm to 10 nm.

### (Comparative Example 10)

An organic electroluminescent element of Comparative Example 10 was produced in the same manner as in Example 3, except that the deposition rate of the hole transport material 3 was changed from 0.05 nm/sec to 0.025 nm/sec and that the thickness of the second hole transport layer was changed from 3 nm to 1 nm.

### (Comparative Example 11)

An organic electroluminescent element of Comparative Example 11 was produced in the same manner as in Example 2, except that the deposition rate of the hole transport material 2 was changed from 0.05 nm/sec to 0.005 nm/sec.

### (Comparative Example 12)

An organic electroluminescent element of Comparative Example 12 was produced in the same manner as in Example 2, except that the deposition rate of the hole transport material 2 was changed from 0.05 nm/sec to 0.01 nm/sec.

### (Comparative Example 13)

An organic electroluminescent element of Comparative Example 13 was produced in the same manner as in Example 2, except that the deposition rate of the hole transport material 2 was changed from 0.05 nm/sec to 0.25 nm/sec.

### (Comparative Example 14)

An organic electroluminescent element of Comparative Example 14 was produced in the same manner as in Example 3, except that the deposition rate of the hole transport material 3 was changed from 0.05 nm/sec to 0.005 nm/sec.

### (Comparative Example 15)

An organic electroluminescent element of Comparative Example 15 was produced in the same manner as in Example 3, except that the deposition rate of the hole transport material 3 was changed from 0.05 nm/sec to 0.01 nm/sec.

### (Comparative Example 16)

An organic electroluminescent element of Comparative Example 16 was produced in the same manner as in Example 3, except that the deposition rate of the hole transport material 3 was changed from 0.05 nm/sec to 0.25 nm/sec.

### (Comparative Example 17)

An organic electroluminescent element of Comparative Example 17 was produced in the same manner as in Example 4, except that the deposition rate of the hole transport material 4 was changed from 0.05 nm/sec to 0.005 nm/sec.

### (Comparative Example 18)

An organic electroluminescent element of Comparative Example 18 was produced in the same manner as in Example 4, except that the deposition rate of the hole transport material 4 was changed from 0.05 nm/sec to 0.01 nm/sec.

### (Comparative Example 19)

An organic electroluminescent element of Comparative Example 19 was produced in the same manner as in Example 4, except that the deposition rate of the hole transport material 4 was changed from 0.05 nm/sec to 0.25 nm/sec.

### (Test and Evaluation of Durability)

Each of the organic electroluminescent elements of Examples 1 to 7 and Comparative Examples 1 to 19 was measured for brightness half-life from the initial brightness (2,000 cd/m²) using a durability evaluation device (product of EHC).

The durability was evaluated based on the brightness half-life of a specific Comparative Example regarded as 100. The brightness half lives of the other Comparative Examples and Examples than the specific Comparative Example were evaluated as the relative values to that of the specific Comparative Example. For example, the organic electroluminescent element of Example 1 was found to have a brightness half-life of 313 relative to 100 of the brightness half-life of Comparative Example 1. In other words, the organic electroluminescent element of Example 1 was 3.13-fold better in durability than that of Comparative Example 1. The results are shown in the following Tables 1 to 3.

**Table 1**

| | Hole Transport Material | Ra(nm) | t(nm) | Ra/t | Brightness Half-Life |
|---|---|---|---|---|---|
| Ex. 1 | Hole Transport Material 1 | 0.334 | 3 | 0.111 | 313 |
| Ex. 2 | Hole Transport Material 2 | 0.298 | 3 | 0.099 | 261 |
| Ex. 3 | Hole Transport Material 3 | 0.346 | 3 | 0.115 | 269 |
| Ex. 4 | Hole Transport Material 4 | 0.984 | 3 | 0.328 | 278 |
| Comp. Ex. 1 | Hole Transport Material 5 | 0.265 | 3 | 0.088 | 100 |
| Comp. Ex. 2 | Hole Transport Material 6 | 0.192 | 3 | 0.064 | 143 |
| Comp. Ex. 3 | Hole Transport Material 7 | 0.232 | 3 | 0.077 | 188 |
| Comp. Ex. 4 | Hole Transport Material 8 | 1.129 | 3 | 0.376 | 149 |

In Table 1, each brightness half-life is relative to the brightness half-life of Comparative Example 1 which is a standard for evaluation.

**Table 2-1**

| | Hole Transport Material | Deposition rate (nm/sec) | Ra(nm) | t(nm) | Ra/t | Brightness Half-Life |
|---|---|---|---|---|---|---|
| Ex. 1 | Hole Transport Material 1 | 0.05 | 0.334 | 3 | 0.111 | 110.1 |
| Comp. Ex. 5 | Hole Transport Material 1 | 0.005 | 0.207 | 3 | 0.069 | 101.3 |
| Comp. Ex. 6 | Hole Transport Material 1 | 0.01 | 0.229 | 3 | 0.076 | 100 |
| Comp. Ex. 7 | Hole Transport Material 1 | 0.25 | 1.121 | 3 | 0.374 | 100.6 |

In Table 2-1, each brightness half-life is relative to the brightness half-life of Comparative Example 6 which is a standard for evaluation.

**Table 2-2**

| | Hole Transport Material | Deposition rate (nm/sec) | Ra (nm) | t(nm) | Ra/t | Brightness Half-Life |
|---|---|---|---|---|---|---|
| Ex. 2 | Hole Transport Material 2 | 0.05 | 0.298 | 3 | 0.099 | 111.7 |
| Comp. Ex. 11 | Hole Transport Material 2 | 0.005 | 0.198 | 3 | 0.066 | 97.2 |
| Comp. Ex. 12 | Hole Transport Material 2 | 0.01 | 0.233 | 3 | 0.078 | 100 |
| Comp. Ex. 13 | Hole Transport Material 2 | 0.25 | 1.033 | 3 | 0.344 | 99.8 |

In Table 2-2, each brightness half-life is relative to the brightness half-life of Comparative Example 12 which is a standard for evaluation.

**Table 2-3**

| | Hole Transport Material | Deposition rate (nm/sec) | Ra(nm) | t(nm) | Ra/t | Brightness Half-Life |
|---|---|---|---|---|---|---|
| Ex. 3 | Hole Transport Material 3 | 0.05 | 0.346 | 3 | 0.115 | 112.3 |
| Comp. Ex. 14 | Hole Transport Material 3 | 0.005 | 0.211 | 3 | 0.070 | 101.1 |
| Comp. Ex. 15 | Hole Transport Material 3 | 0.01 | 0.245 | 3 | 0.082 | 100 |
| Comp. Ex. 16 | Hole Transport Material 3 | 0.25 | 1.168 | 3 | 0.389 | 100.3 |

In Table 2-3, each brightness half-life is relative to the brightness half-life of Comparative Example 15 which is a standard for evaluation.

**Table 2-4**

| | Hole Transport Material | Deposition rate (nm/sec) | Ra(nm) | t(nm) | Ra/t | Brightness Half-Life |
|---|---|---|---|---|---|---|
| Ex. 4 | Hole Transport Material 4 | 0.05 | 0.984 | 3 | 0.328 | 110.6 |
| Comp. Ex. 17 | Hole Transport Material 4 | 0.005 | 0.263 | 3 | 0.088 | 102.4 |
| Comp. Ex. 18 | Hole Transport Material 4 | 0.01 | 0.276 | 3 | 0.092 | 100 |
| Comp. Ex. 19 | Hole Transport Material 4 | 0.25 | 1.356 | 3 | 0.452 | 96.9 |

In Table 2-4, each brightness half-life is relative to the brightness half-life of Comparative Example 18 which is a standard for evaluation.

**Table 3**

| | Hole Transport Material | Deposition rate (nm/sec) | Ra(nm) | t(nm) | Ra/t | Brightness Half-Life |
|---|---|---|---|---|---|---|
| Ex. 5 | Hole Transport Material 1 | 0.25 | 1.790 | 10 | 0.179 | 144 |
| Ex. 6 | Hole Transport Material 2 | 0.25 | 1.057 | 10 | 0.106 | 174 |
| Comp. Ex. 8 | Hole Transport Material 5 | 0.025 | 3.520 | 10 | 0.352 | 100 |
| Comp. Ex. 9 | Hole Transport Material 7 | 0.025 | 0.255 | 10 | 0.026 | 100 |
| Ex. 7 | Hole Transport Material 7 | 0.25 | 0.258 | 1 | 0.258 | 131 |
| Comp. Ex. 10 | Hole Transport Material 3 | 0.025 | 0.084 | 1 | 0.084 | 100 |

In Table 3, the brightness half-lives of Examples 5 and 6 are relative to the brightness half-lives of Comparative Examples 8 and 9 which are a standard for evaluation, and the brightness half-life of Example 7 is relative to the brightness half-life of Comparative Example 10 which is a standard for evaluation.

### (Measurement Method and Evaluation of Increase Rate of Voltage)

Each of the organic electroluminescent elements of Examples 1 to 7 and Comparative Examples 1 to 19 was measured for increase rate of voltage as follows.

Specifically, the increase rate of voltage was determined based on the ratio (V₁₀₀ₕ/V₀) where Vo denotes a stable drive voltage measured at the initial state of driving and V₁₀₀ₕ denotes a drive voltage after 100 hours continuous driving. Notably, the drive voltages were measured using Source Measure Unit Model 2400 (product of KEITHLEY). The drive voltage after 100 hours driving was measured after DC voltage had been applied to the organic electroluminescent element to allow it to emit light. The results are shown in the following Tables 4-1 and 4-2.

**Table 4-1**

| | Hole Transport Material | Ra/t | Increase Rate of Voltage After 100 h (%) |
|---|---|---|---|
| Ex. 1 | Hole Transport Material 1 | 0.111 | 6.0 |
| Ex. 2 | Hole Transport Material 2 | 0.099 | 5.8 |
| Ex. 3 | Hole Transport Material 3 | 0.115 | 4.8 |
| Ex. 4 | Hole Transport Material 4 | 0.328 | 5.6 |
| Comp. Ex. 1 | Hole Transport Material 5 | 0.088 | 10.8 |
| Comp. Ex. 2 | Hole Transport Material 6 | 0.064 | 7.9 |
| Comp. Ex. 3 | Hole Transport Material 7 | 0.077 | 7.9 |
| Comp. Ex. 4 | Hole Transport Material 8 | 0.376 | 9.3 |

**Table 4-2**

| | Hole Transport Material | Ra/t | Increase Rate of Voltage After 100 h (%) |
|---|---|---|---|
| Ex. 5 | Hole Transport Material 1 | 0.179 | 6.2 |
| Ex. 6 | Hole Transport Material 2 | 0.106 | 6.3 |
| Ex. 7 | Hole Transport Material 7 | 0.258 | 5.7 |
| Comp. Ex. 5 | Hole Transport Material 1 | 0.069 | 8.0 |
| Comp. Ex. 6 | Hole Transport Material 1 | 0.076 | 8.1 |
| Comp. Ex. 7 | Hole Transport Material 1 | 0.374 | 7.9 |
| Comp. Ex. 8 | Hole Transport Material 5 | 0.352 | 11.0 |
| Comp. Ex. 9 | Hole Transport Material 7 | 0.026 | 7.8 |
| Comp. Ex. 10 | Hole Transport Material 3 | 0.084 | 7.2 |
| Comp. Ex. 11 | Hole Transport Material 2 | 0.066 | 7.7 |
| Comp. Ex. 12 | Hole Transport Material 2 | 0.078 | 7.6 |
| Comp. Ex. 13 | Hole Transport Material 2 | 0.344 | 7.5 |
| Comp. Ex. 14 | Hole Transport Material 3 | 0.070 | 7.1 |
| Comp. Ex. 15 | Hole Transport Material 3 | 0.082 | 7.1 |
| Comp. Ex. 16 | Hole Transport Material 3 | 0.389 | 7.3 |
| Comp. Ex. 17 | Hole Transport Material 4 | 0.088 | 7.7 |
| Comp. Ex. 18 | Hole Transport Material 4 | 0.092 | 7.6 |
| Comp. Ex. 19 | Hole Transport Material 4 | 0.452 | 7.7 |

As shown in Tables 4-1 and 4-2, the organic electroluminescent elements of Examples 1 to 7 were found to be lower in increase rate of voltage after 100 hours (%) than the organic electroluminescent elements of Comparative Examples 1 to 19.

### (Measurement Method and Evaluation of Interlayer Adhesiveness)

After each of the organic electroluminescent elements of Examples 1 to 7 and Comparative Examples 1 to 19 was driven for 100 hours, the seal can was removed and then CELLOPHANE TAPE ("CT24," product of NICHIBAN CO., 56 LTD.) was attached to the organic electroluminescent element to peel it off. The attached matter onto the tape was dissolved in a solvent, and the resultant solution was analyzed through high performance liquid chromatography. The interlayer adhesiveness was evaluated according to the following criteria:
A: the organic materials contained in the element were not detected; and
B: the organic materials contained in the element were detected. The results are shown in the following Tables 5-1 and 5-2.

**Table 5-1**

| | Hole Transport Material | Ra/t | Adhesiveness |
|---|---|---|---|
| Ex. 1 | Hole Transport Material 1 | 0.111 | A |
| Ex. 2 | Hole Transport Material 2 | 0.099 | A |
| Ex. 3 | Hole Transport Material 3 | 0.116 | A |
| Ex. 4 | Hole Transport Material 4 | 0.328 | A |
| Comp. Ex. 1 | Hole Transport Material 5 | 0.088 | B |
| Comp. Ex. 2 | Hole Transport Material 6 | 0.064 | B |
| Comp. Ex. 3 | Hole Transport Material 7 | 0.077 | B |
| Comp. Ex. 4 | Hole Transport Material 8 | 0.376 | B |

**Table 5-2**

| | Hole Transport Material | Ra/t | Adhesiveness |
|---|---|---|---|
| Ex. 5 | Hole Transport Material 1 | 0.179 | A |
| Ex. 6 | Hole Transport Material 2 | 0.106 | A |
| Ex. 7 | Hole Transport Material 7 | 0.258 | A |
| Comp. Ex. 5 | Hole Transport Material 1 | 0.069 | B |
| Comp. Ex. 6 | Hole Transport Material 1 | 0.076 | B |
| Comp. Ex. 7 | Hole Transport Material 1 | 0.374 | B |
| Comp. Ex. 8 | Hole Transport Material 5 | 0.352 | B |
| Comp. Ex. 9 | Hole Transport Material 7 | 0.026 | B |
| Comp. Ex. 10 | Hole Transport Material 3 | 0.084 | B |
| Comp. Ex. 11 | Hole Transport Material 2 | 0.066 | B |
| Comp. Ex. 12 | Hole Transport Material 2 | 0.078 | B |
| Comp. Ex. 13 | Hole Transport Material 2 | 0.344 | B |
| Comp. Ex. 14 | Hole Transport Material 3 | 0.070 | B |
| Comp. Ex. 15 | Hole Transport Material 3 | 0.082 | B |
| Comp. Ex. 16 | Hole Transport Material 3 | 0.389 | B |
| Comp. Ex. 17 | Hole Transport Material 4 | 0.088 | B |
| Comp. Ex. 18 | Hole Transport Material 4 | 0.092 | B |
| Comp. Ex. 19 | Hole Transport Material 4 | 0.452 | B |

### (Relationship between Deposition Rate and Film Density)

There was tested the extent to which the film density of each of the films formed through deposition of each hole transport material changed depending on the deposition rate at which the hole transport materials 1 to 8 were deposited. The results are shown in the following Table 6. The film density was measured by the X-ray reflectivity method using an X-ray diffraction device ATX-G (product of Rigaku Corporation).

**Table 6**

| Film density (g/cm³) | | | | |
|---|---|---|---|---|
| | Deposition Rate (nm/sec) | | | |
| | 0.005 | 0.01 | 0.05 | 0.25 |
| Hole Transport Material 1 | 1.22 | 1.22 | 1.21 | 1.22 |
| Hole Transport Material 2 | 1.22 | 1.22 | 1.23 | 1.23 |
| Hole Transport Material 3 | 1.20 | 1.21 | 1.21 | 1.20 |
| Hole Transport Material 4 | 1.21 | 1.22 | 1.22 | 1.22 |
| Hole Transport Material 5 | 1.22 | 1.21 | 1.22 | 1.21 |
| Hole Transport Material 6 | 1.21 | 1.21 | 1.20 | 1.22 |
| Hole Transport Material 7 | 1.20 | 1.22 | 1.21 | 1.21 |
| Hole Transport Material 8 | 1.23 | 1.22 | 1.23 | 1.22 |

### Industrial Applicability

The present invention can provide an organic electroluminescent element having excellent durability and a method for producing the organic electroluminescent element, which are suitably be applicable in practical production of organic electroluminescent elements.

### Reference Sings List

- 1: Substrate
- 2: Anode
- 3: Hole injection layer
- 4: Hole transport layer
- 5: Luminescent layer
- 6: Electron transport layer
- 7: Electron injection layer
- 8: Cathode
- 10: Organic electroluminescent element

## Claims

1. An organic electroluminescent element comprising:
a first electrode;
at least one organic deposition layer; and
a second electrode,
the first electrode, the organic deposition layer, and the second electrode being formed in this order,
wherein the organic deposition layer satisfies the relationship 0.093 < Ra/t < 0.340 where Ra denotes a surface roughness of a surface of the organic deposition layer, the surface being at the side of the second electrode, and t denotes a thickness of the organic deposition layer.

2. The organic electroluminescent element according to claim 1, wherein the organic deposition layer contains a luminescent layer, an adjacent layer to the luminescent layer, or both of the luminescent layer and the adjacent layer.

3. The organic electroluminescent element according to claim 2, wherein the adjacent layer is a hole transport layer.

4. The organic electroluminescent element according to any one of claims 1 to 3, wherein the first electrode is an anode and the second electrode is a cathode.

5. The organic electroluminescent element according to any one of claims 2 to 4, wherein the luminescent layer contains a phosphorescent material.

6. The organic electroluminescent element according to claim 5, wherein the phosphorescent material is a platinum complex.

7. The organic electroluminescent element according to any one of claims 1 to 6, wherein the thickness t of the organic deposition layer is 1 nm to 10 nm.

8. A method for producing an organic electroluminescent element comprising a first electrode, at least one organic deposition layer containing a luminescent layer, and a second electrode, the first electrode, the organic deposition layer, and the second electrode being formed in this order, the method comprising:
depositing the organic deposition layer so as to satisfy the relationship 0.093 < Ra/t < 0.340, where Ra denotes a surface roughness of a surface of the organic deposition layer, the surface being at the side of the second electrode, and t denotes a thickness of the organic deposition layer.
